(19) Europäisches Patentamt
European Patent Office
Office européen des brevets

(11) EP 3 576 174 A1

(12) EUROPEAN PATENT APPLICATION
published in accordance with Art. 153(4) EPC

(43) Date of publication:
**04.12.2019 Bulletin 2019/49**

(21) Application number: **18744086.2**

(22) Date of filing: **24.01.2018**

(51) Int Cl.:
***H01L 51/50*** (2006.01) ***C08G 61/12*** (2006.01)
***C08L 65/00*** (2006.01) ***C09D 11/00*** (2014.01)
***F21S 2/00*** (2016.01) ***G02F 1/13357*** (2006.01)
***G09F 9/30*** (2006.01) ***H01L 27/32*** (2006.01)
***F21Y 115/15*** (2016.01)

(86) International application number:
**PCT/JP2018/002126**

(87) International publication number:
**WO 2018/139487 (02.08.2018 Gazette 2018/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **26.01.2017 PCT/JP2017/002655**

(71) Applicant: **Hitachi Chemical Company, Ltd.**
**Chiyoda-ku**
**Tokyo 100-6606 (JP)**

(72) Inventors:
- **SUGIOKA Tomotsugu**
  **Tokyo 100-6606 (JP)**
- **ISHITSUKA Kenichi**
  **Tokyo 100-6606 (JP)**
- **YOSHINARI Yuki**
  **Tokyo 100-6606 (JP)**
- **HONNA Ryo**
  **Tokyo 100-6606 (JP)**
- **SAKUMA Hirotaka**
  **Tokyo 100-6606 (JP)**

(74) Representative: **Adam, Holger**
**Kraus & Weisert**
**Patentanwälte PartGmbB**
**Thomas-Wimmer-Ring 15**
**80539 München (DE)**

# (54) ORGANIC ELECTRONICS MATERIAL, INK COMPOSITION, ORGANIC LAYER, ORGANIC ELECTRONICS ELEMENT, ORGANIC ELECTROLUMINESCENCE ELEMENT, DISPLAY ELEMENT, ILLUMINATION DEVICE, AND DISPLAY DEVICE

(57) One embodiment relates to an organic electronic material containing a charge transport polymer or oligomer having a crosslinking group represented by formula (1) shown below at two or more terminal portions.

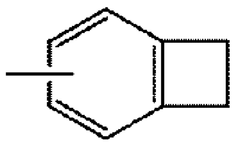

(1)

EP 3 576 174 A1

FIG. 1

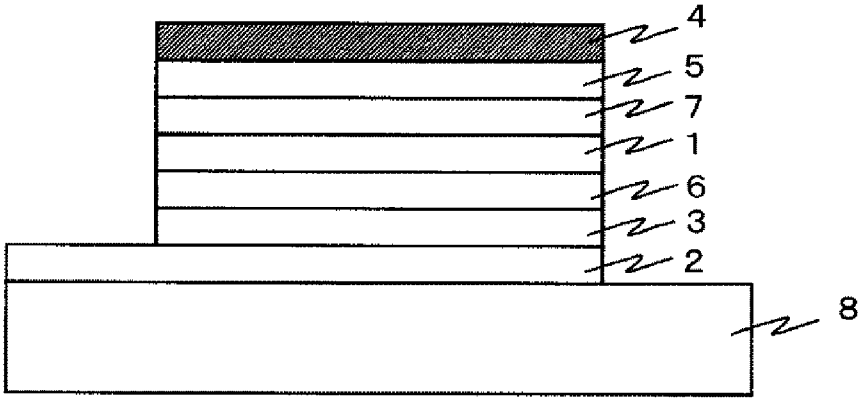

## Description

### Technical Field

The present invention relates to an organic electronic material, an ink composition, an organic layer, an organic electronic element, an organic electroluminescent element (also referred to as an organic EL element), a display element, an illumination device, and a display device.

### Background Art

Organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

Depending on the organic materials used, organic EL elements are broadly classified into two types: low-molecular weight type organic EL elements and polymer type organic EL elements. In polymer type organic EL elements, a polymer compound is used as the organic material, whereas in low-molecular weight type organic EL elements, a low-molecular weight compound is used. On the other hand, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays.

Accordingly, much development of materials suitable for wet processes is being pursued. For example, investigations are being undertaken into the formation of multilayer structures of organic thin films (organic layers) using compounds having polymerizable groups, and polymer compounds have been disclosed that enable curing of the above organic layers by using a benzocyclobutene as a crosslinking group to achieve intramolecular and/or intermolecular crosslinking (for example, see Patent Literature 1 and Patent Literature 2).

### Citation List

### Patent Literature

PLT 1: JP 2008-106241 A
PLT 2: JP 2010-215886 A

### Summary of Invention

### Technical Problem

However, from the viewpoint of curability, the polymer compounds disclosed in Patent Literature 1 have room for improvement in terms of the film formability properties in wet processes.

Further, in the polymer compounds disclosed in Patent Literature 2, because non-terminal units (structural units) on the main chain have a crosslinking group, when the amount of the crosslinking group introduced into the polymer is changed, the conductivity of the organic thin film (organic layer) formed from the polymer compound also tends to change. In other words, the composition of the main chain changes significantly depending on the amount of the crosslinking group that is introduced, and the charge (hole) transport properties also change significantly. As a result, the light-emitting position (the position of hole and electron recombination) is offset from the original ideal position (for example, is offset from the center of the light-emitting layer toward the hole transport layer side), leading to a shortening of the lifespan.

The present invention has been developed in light of the above circumstances, and has an object of providing an organic electronic material and an ink composition that are suitable for improving the film formability in wet processes and the lifespan characteristics of organic electronic elements. Further, the present invention also has the objects of providing an organic layer that is suitable for improving the lifespan characteristics of organic electronic elements, as well as an organic electronic element, an organic EL element, a display element, and illumination device and a display device that exhibit excellent lifespan characteristics.

Solution to Problem

As a result of intensive investigation, the inventors of the present invention discovered that an organic electronic material containing at least a charge transport polymer or oligomer having a specific structure was effective in improving the lifespan characteristics of organic electronic elements and organic EL elements, enabling them to complete the present invention.

In other words, the present invention relates to the following aspects [1] to [21].

[1] An organic electronic material containing a charge transport polymer or oligomer having a crosslinking group represented by formula (1) shown below at two or more terminal portions.

[Chemical formula 1]

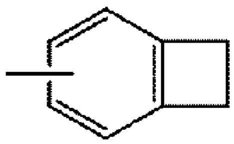

(1)

[2] The organic electronic material according to [1], wherein the charge transport polymer or oligomer has three or more terminal portions, and at least two of the three or more terminal portions have a crosslinking group represented by formula (1).

[3] The organic electronic material according to [1] or [2], wherein the charge transport polymer or oligomer is a copolymer of monomers that include at least a monomer containing a structural unit having charge transport properties and a monomer containing a crosslinking group represented by formula (1).

[4] The organic electronic material according to any one of [1] to [3], wherein the charge transport polymer or oligomer is a copolymer of monomers that include at least a monomer containing a structural unit having hole transport properties and a monomer containing a crosslinking group represented by formula (1).

[5] The organic electronic material according to any one of [1] to [4], wherein the charge transport polymer or oligomer contains at least a divalent structural unit L and a monovalent structural unit T1 containing a crosslinking group represented by formula (1), the structural unit L is at least one type of structural unit selected from the group consisting of a structural unit that is a substituted or unsubstituted aromatic amine structure and a structural unit that is a substituted or unsubstituted carbazole structure, the structural unit T1 is a structural unit that is at least one type of structure selected from the group consisting of a structure represented by formula (1) and a substituted or unsubstituted aromatic ring structure to which a crosslinking group represented by formula (1) is bonded via a divalent organic group, and the divalent organic group is a group that contains at least one group selected from the group consisting of an aliphatic organic group and a substituted or unsubstituted aromatic organic group.

[6] The organic electronic material according to [5], wherein the charge transport polymer or oligomer further contains at least one type of structural unit selected from the group consisting of a trivalent or higher structural unit B and a monovalent structural unit T2 that does not have a crosslinking group represented by formula (1), the structural unit B is a structural unit that is at least one type of structure selected from the group consisting of a substituted or unsubstituted aromatic amine structure, a substituted or unsubstituted carbazole structure and a substituted or unsubstituted condensed polycyclic aromatic hydrocarbon structure, and the structural unit T2 is a structural unit that is a substituted or unsubstituted aromatic ring structure.

[7] The organic electronic material according to [5] or [6], wherein adjacent structural units are bonded together by a single bond between a carbon atom on an aromatic ring of one structural unit and a carbon atom on an aromatic ring of another structural unit.

[8] The organic electronic material according to any one of [1] to [7], wherein the charge transport polymer or oligomer has a branched structure, and the branched structure includes a multi-branched structure having one or more branched portions and three or more chains bonded to one of the one or more branched portions, wherein each of the three or more chains has one or more other branched portions and two or more other chains bonded to one of the one or more other branched portions.

[9] An ink composition containing the organic electronic material according to any one of [1] to [8], and a solvent.

[10] An organic layer formed using the organic electronic material according to any one of [1] to [8] or the ink composition according to [9].

[11] An organic electronic element containing at least one layer of the organic layer according to [10].

[12] The organic electronic element according to [11], containing at least an anode and cathode pair, and the organic layer disposed between the anode and the cathode.

[13] An organic electroluminescent element containing at least one layer of the organic layer according to [10].
[14] An organic electroluminescent element formed by stacking at least a substrate, an anode, a light-emitting layer and a cathode, wherein the light-emitting layer is the organic layer according to [10].
[15] An organic electroluminescent element formed by stacking at least a substrate, an anode, a hole injection layer, a hole transport layer, a light-emitting layer and a cathode, wherein at least one layer among the hole injection layer, the hole transport layer and the light-emitting layer is the organic layer according to [10].
[16] The organic electroluminescent element according to [14] or [15], formed by stacking at least a substrate, an anode, a hole injection layer, a hole transport layer, a light-emitting layer, an electron transport layer, an electron injection layer and a cathode.
[17] The organic electroluminescent element according to any one of [13] to [16], wherein the substrate is a flexible substrate.
[18] The organic electroluminescent element according to any one of [13] to [17], wherein the substrate is a resin film substrate.
[19] A display element containing the organic electroluminescent element according to any one of [13] to [18].
[20] An illumination device containing the organic electroluminescent element according to any one of [13] to [18].
[21] A display device containing the illumination device according to [20], and a liquid crystal element as a display unit.

The present invention is related to the subject matter disclosed in International Patent Application No. PCT/JP2017/002655, filed January 26, 2017, the entire contents of which are incorporated by reference herein.

Advantageous Effects of Invention

The present invention is able to provide an organic electronic material and an ink composition that are suitable for improving the film formability in wet processes and the lifespan characteristics of organic electronic elements. Further, the present invention can also provide an organic layer that is suitable for improving the lifespan characteristics of organic electronic elements, as well as an organic electronic element, an organic EL element, a display element, and illumination device and a display device that exhibit excellent lifespan characteristics.

Brief Description of Drawings

FIG. 1 is a cross-sectional schematic view illustrating one example of an organic EL element that represents one embodiment of the present invention.

Description of Embodiments

Embodiments of the present invention are described below.

<Organic Electronic Material>

An organic electronic material of one embodiment of the present invention contains a charge transport polymer or oligomer having a crosslinking group represented by formula (1) at two or more terminal portions. This organic electronic material may contain only one type of the charge transport polymer or oligomer, or may contain two or more types. The charge transport polymer or oligomer is preferred to low-molecular weight compounds in terms of exhibiting superior film formability in wet processes.

[Charge Transport Polymer or Oligomer]

The charge transport polymer or oligomer in an embodiment of the present invention (in the following description, the charge transport polymer or oligomer is sometimes referred to as simply "the charge transport polymer") contains a crosslinking group represented by formula (1) at terminal portions, and is a polymer or oligomer that has the ability to transport an electric charge. The crosslinking group represented by formula (1) is present at two or more terminal portions per one molecule of the charge transport polymer. The charge transport polymer may be linear, or may have a branched structure. The charge transport polymer preferably contains at least a divalent structural unit L having charge transport properties and a monovalent structural unit T that forms the terminal portions, and may also contain a trivalent or higher structural unit B that forms a branched portion. The charge transport polymer may have only one type of each of these structural units, or may contain a plurality of types of each structural unit. In the charge transport polymer, the various structural units are bonded together at "monovalent" to "trivalent or higher" bonding sites. The structural unit L, the structural unit B and the structural unit T are all structural units derived from monomers used for introducing structural

units by a copolymerization reaction.

In embodiments of the present invention, a "terminal portion" describes a structural unit which, among the various structural units contained in the charge transport polymer, forms a structural unit T described below. This terminal portion (structural unit T) is bonded directly to a structural unit L (described below) or a structural unit B (described below) contained in the charge transport polymer, and forms a portion of the main chain or a side chain. The "main chain" describes a chain of structural units containing the structural unit L, the structural unit B (an optionally included unit) and the structural unit T. The "main chain" is the longest chain within the charge transport polymer. A "side chain" describes a portion that branches from the main chain due to a structural unit B, and preferably describes a chain of structural units containing the structural unit L, the structural unit B (an optionally included unit) and the structural unit T. Further, the term "structural unit" describes a structure, within the structure of the charge transport polymer, that is derived from the structure of one of the monomers (a monomer unit structure) used in synthesizing the charge transport polymer. Accordingly, in those cases where a monomer having a structural unit T structure that forms a terminal portion has a crosslinking group represented by formula (1), a charge transport polymer synthesized using this monomer will have a crosslinking group represented by formula (1) at a terminal portion (structural unit T), and corresponds with a charge transport polymer containing a crosslinking group represented by formula (1) at a terminal portion. On the other hand, in those cases where a monomer having a structural unit T structure that forms a terminal portion does not have a crosslinking group represented by formula (1), even if a monomer having a structural unit L structure has a crosslinking group represented by formula (1), the charge transport polymer synthesized using these monomers will not have a crosslinking group represented by formula (1) at a terminal portion (structural unit T), and therefore does not correspond with a charge transport polymer containing a crosslinking group represented by formula (1) at a terminal portion. By having a crosslinking group represented by formula (1) at terminal portions, the charge transport polymer is able to exhibit a combination of satisfactory curability and good suppression of any effect on the conductivity of the charge transport polymer.

The charge transport polymer in an embodiment of the present invention contains a crosslinking group represented by formula (1) at two or more terminal portions. In other words, at least a portion of the aforementioned structural units T that form the terminal portions are either a crosslinking group represented by formula (1) or a structural unit having a crosslinking group represented by formula (1).

In other words, the charge transport polymer in an embodiment of the present invention is a copolymer of monomers that include at least a monomer containing a structural unit having charge transport properties, and a monomer containing a crosslinking group represented by formula (1). Further, the charge transport polymer in an embodiment of the present invention is preferably a copolymer of monomers that include at least a monomer containing a structural unit having hole transport properties, and a monomer containing a crosslinking group represented by formula (1).

In one preferred embodiment, the charge transport polymer has a branched structure, and the branched structure has one or more branched portions and three or more chains bonded to one of the one or more branched portions. It is more preferable that the branched structure includes a multi-branched structure having one or more branched portions and three or more chains bonded to one of the one or more branched portions, wherein each of the three or more chains has one or more other branched portions and two or more other chains bonded to one of the one or more other branched portions. Here, the term "chain" means a chain of structural units that includes at least the structural unit L, and is preferably a chain of structural units including the structural unit L, the structural unit B (an optionally included unit) and the structural unit T.

In a preferred embodiment, the charge transport polymer has a branched structure, and the branched structure has one or more structural units B and three or more structural units L bonded to one of the one or more structural units B. It is more preferable that the branched structure includes a multi-branched structure having one or more structural units B and three or more structural units L bonded to one of the one or more structural units B, wherein each of the three or more structural units L has another structural unit B bonded to the each of the three or more structural units L and two or more other structural units L bonded to the another structural unit B.

(Structure)

Examples of partial structures contained in the charge transport polymer include the structures described below. However, the charge transport polymer is not limited to polymers having the following partial structures. In the partial structures, "L" represents a structural unit L, "T" represents a structural unit T, and "B" represents a structural unit B. In the present description, an "*" in a formula indicates a bonding site with another structural unit. In the following partial structures, the plurality of L structural units may be structural units having the same structure or structural units having mutually different structures. This also applies for the B and T structural units.

Linear Charge Transport Polymers

[Chemical formula 2] T-L-L-L-L-*

Charge Transport Polymers having Branched Structures

[Chemical formula 3]

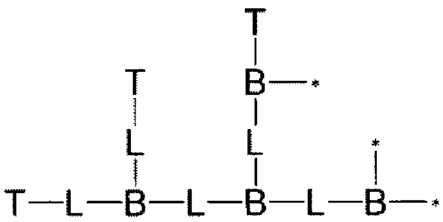

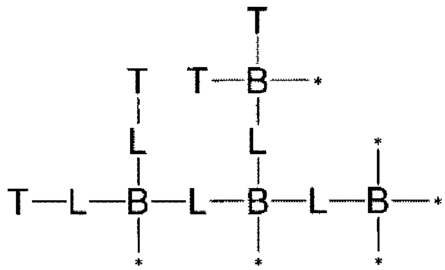

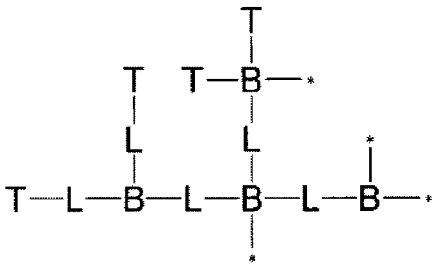

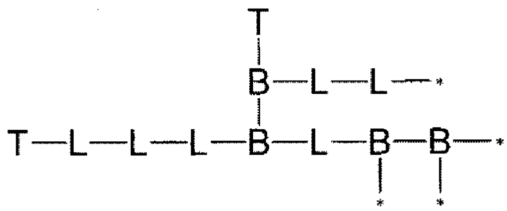

(Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted structures including aromatic amine structures, carbazole structures, thiophene structures, fluorene structures, benzene structures, biphenylene structures, terphenylene structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, benzotriazole structures, and structures containing one, or two or more, of the above structures. The aromatic amine structures are preferably triarylamine structures, and more preferably triphenylamine structures.

In one embodiment, from the viewpoint of obtaining superior hole transport properties, the structural unit L is preferably selected from among substituted or unsubstituted structures including aromatic amine structures, carbazole structures, thiophene structures, fluorene structures, benzene structures, pyrrole structures, and structures containing one, or two or more, of these structures, and is more preferably selected from among substituted or unsubstituted structures including aromatic amine structures, carbazole structures, and structures containing one, or two or more, of these structures. In another embodiment, from the viewpoint of obtaining superior electron transport properties, the structural unit L is preferably selected from among substituted or unsubstituted structures including fluorene structures, benzene structures, phenanthrene structures, pyridine structures, quinoline structures, and structures containing one, or two or more, of these structures.

Specific examples of the structural unit L are shown below. However, the structural unit L is not limited to the following structures.

[Chemical formula 4]

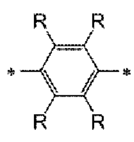
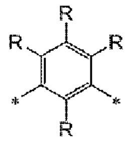
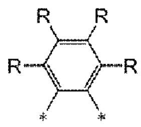
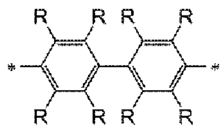
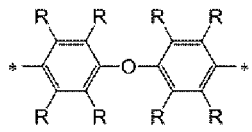
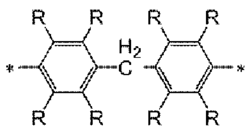
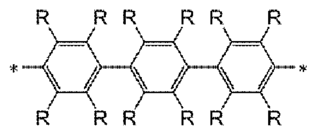
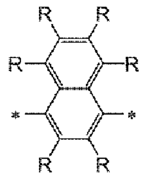
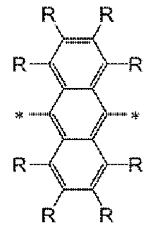
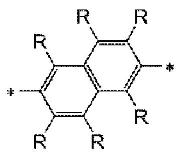
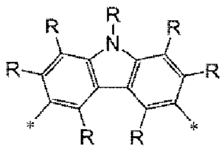
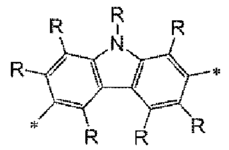
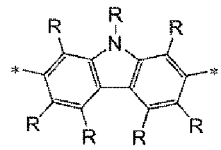
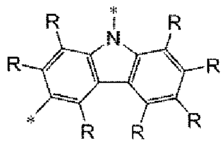
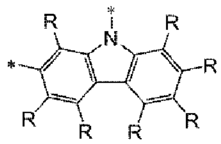
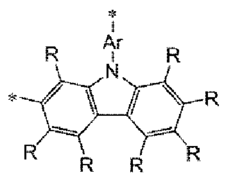
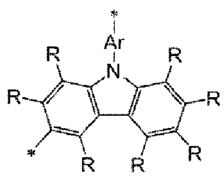
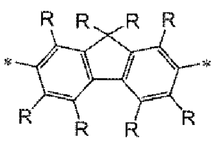
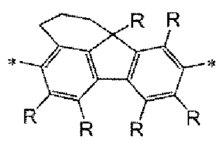
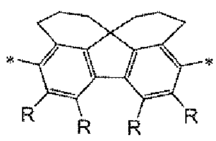
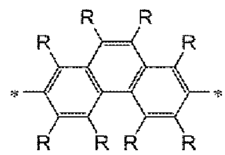
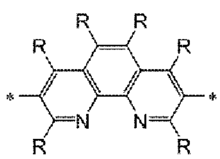
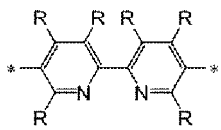
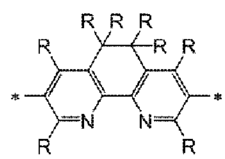
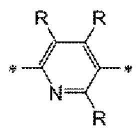
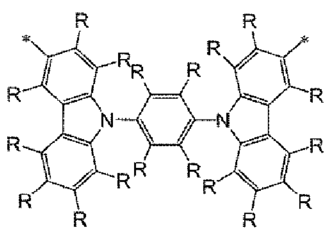
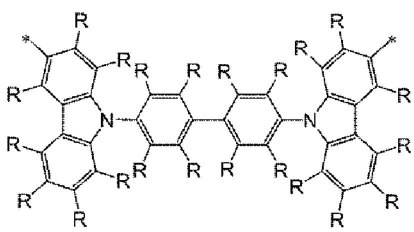

[Chemical formula 5]

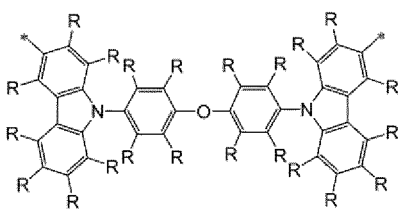

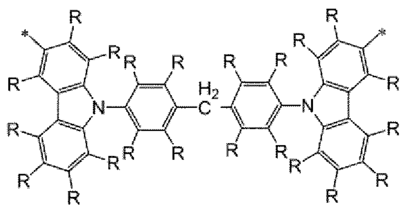

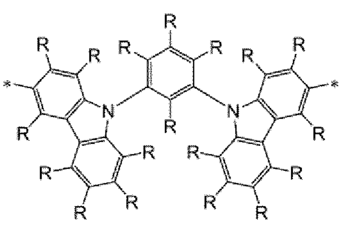

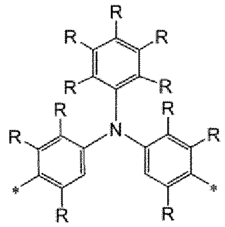

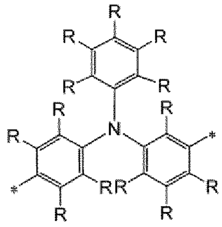

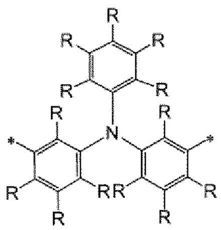

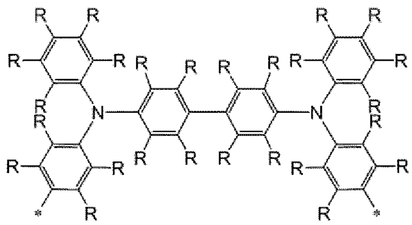

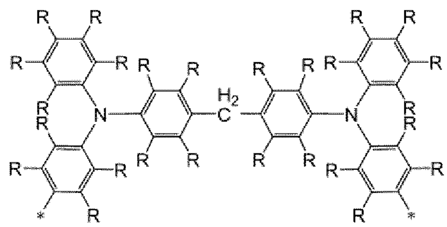

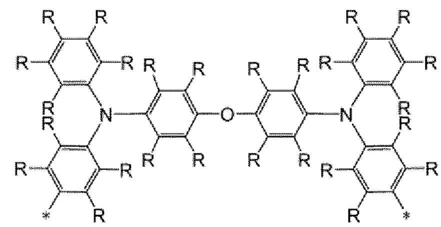

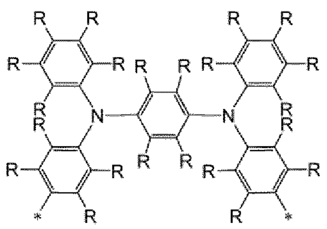

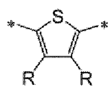

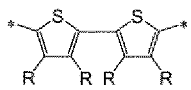

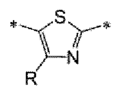

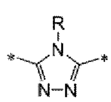

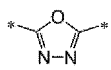

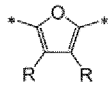

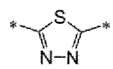

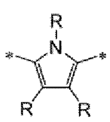

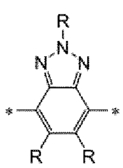

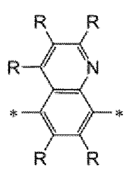

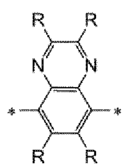

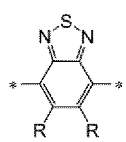

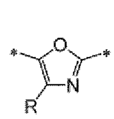

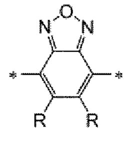

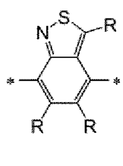

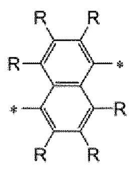

Each R independently represents a hydrogen atom or a substituent. It is preferable that each R is independently selected from a group consisting of $-R^1$, $-OR^2$, $-SR^3$, $-OCOR^4$, $-COOR^5$, $-SiR^6R^7R^8$, halogen atoms, and groups containing a polymerizable functional group described below. Each of $R^1$ to $R^8$ independently represents a hydrogen atom, a linear, cyclic or branched alkyl group of 1 to 22 carbon atoms, or an aryl group or heteroaryl group of 2 to 30 carbon atoms. An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. R is preferably a hydrogen atom, an alkyl group, an aryl group, or an alkyl-substituted aryl group. Ar represents an arylene group or heteroarylene group of 2 to 30 carbon atoms. An arylene group is an atom grouping in which two hydrogen atoms have been removed from an aromatic hydrocarbon. A heteroarylene group is an atom grouping in which two hydrogen atoms have been removed from an aromatic heterocycle. Ar is preferably an arylene group, and is more preferably a phenylene group.

(Structural Unit T)

The structural unit T is a monovalent structural unit that forms a terminal portion of the charge transport polymer. There are no particular limitations on the number of terminals portions formed with a monovalent structural unit T within each molecule of the charge transport polymer, but the number of terminal portions is preferably at least two, and more preferably three or more. However, the charge transport polymer in an embodiment of the present invention has a monovalent structural unit having a crosslinking group represented by formula (1) as a monovalent structural unit T that forms a terminal portion at two or more terminal portions per molecule. As described below, in those cases where, in addition to the terminal portions at which a crosslinking group represented by formula (1) is located, the charge transport polymer also has a terminal portion having another polymerizable functional group, the structural unit T that forms the terminal portion may be a polymerizable structure (for example, a polymerizable functional group such as a pyrrolyl group).

In other words, it is preferable that the charge transport polymer has three or more terminal portions, wherein at least two of those three or more terminal portions have a crosslinking group represented by formula (1).

At least a portion of the structural units T are structural units having a crosslinking group represented by formula (1) (hereafter, these structural units are also referred to as "structural unit T1"). Provided that the charge transport polymer in an embodiment of the present invention has structural units T1 at two or more terminal portions per molecule, there are no particular limitations on the number or type of the other structural units T (hereafter, these other structural units are also referred to as "structural unit T2").

(Structural Unit T1)

The structural unit T1 may have a substituent, and substituents may be bonded together to form a ring. Further, the structural unit T1 may have an aromatic ring, wherein the crosslinking group represented by formula (1) substitutes the aromatic ring via an aliphatic organic group and/or an aromatic organic group.

In those cases where the crosslinking group represented by formula (1) substitutes an aromatic ring via an aliphatic organic group and/or an aromatic organic group, the structural unit T1 becomes a structure that has a bonding site on the aromatic ring. In other words, the structural unit T1 may, for example, be a structural unit represented by formula (1), or may have a substituted or unsubstituted aromatic ring structure in which the crosslinking group represented by formula (1) is bonded to the aromatic ring via a divalent organic group such as a divalent aliphatic organic group and/or aromatic organic group or the like. In those cases where the aromatic ring structure has a substituent, examples of the substituent include the same groups as those described above for the substituent R in relation to the structural unit L.

An "aromatic ring" describes a ring that exhibits aromaticity. The aromatic ring may have a single ring structure such as benzene, or may have a condensed ring structure in which rings are fused together such as naphthalene.

The aromatic ring may an aromatic hydrocarbon such as benzene, naphthalene, anthracene, tetracene, fluorene or phenanthrene, or may be an aromatic heterocycle such as pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole or benzothiophene.

The aromatic ring may also be a structure in which two or more independent rings selected from among single ring or condensed ring structures are bonded together, such as biphenyl, terphenyl or triphenylbenzene.

Examples of the structural unit T1 include units represented by formula (2) or (3) shown below.

[Chemical formula 6]

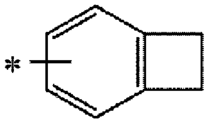

(2)

[Chemical formula 7]

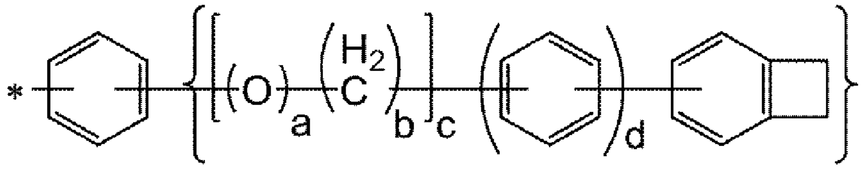

(3)

In formula (3), a to e represent integers, wherein a is 0 or 1, b is from 0 to 20, c is from 1 to 5, d is from 0 to 3, and e is from 1 to 5.

Specific examples of the structural unit T1 are shown below, but the structural unit T1 is not limited to the following specific examples. In the formulas below, "*" indicates a bonding site.

[Chemical formula 8]

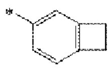
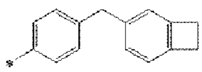
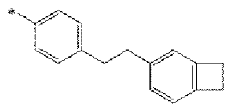
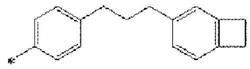
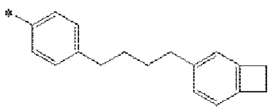
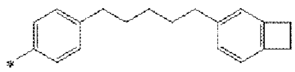
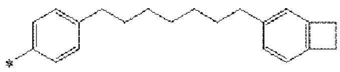
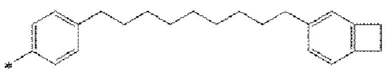
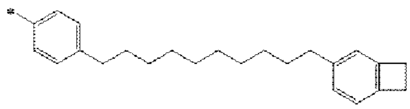
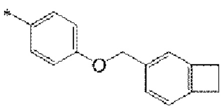
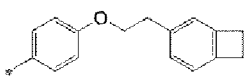
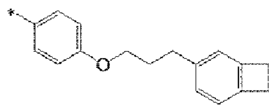
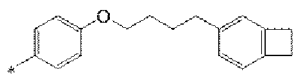
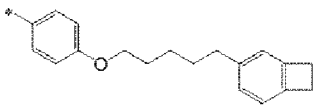
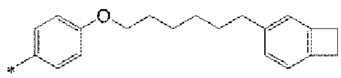
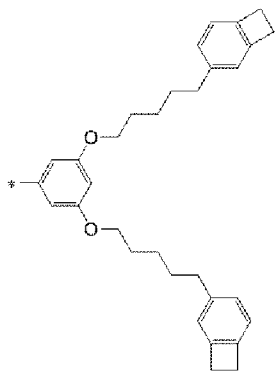
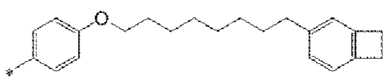
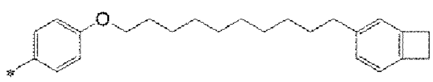
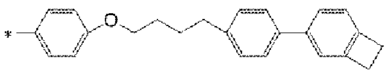

The number of terminal portions having a crosslinking group represented by formula (1) in the charge transport

polymer (namely, the average number per molecule of the polymer) can be determined from the ratio (molar ratio) of the amount added of the corresponding monomer. In other words, the number of crosslinking groups represented by formula (1) per molecule of the charge transport polymer can be determined as an average value using the amount added of the monomer having the crosslinking group represented by formula (1) and the amounts added of the monomers corresponding with the various other structural units during the synthesis of the charge transport polymer, and the weight average molecular weight of the charge transport polymer and the like. Further, the number of terminal portions having a crosslinking group represented by formula (1) can also be calculated as an average value using the ratio between the integral of the signal attributable to the crosslinking group represented by formula (1) and the integral of the total spectrum in the $^1$H-NMR (nuclear magnetic resonance) spectrum of the charge transport polymer, and the weight average molecular weight of the charge transport polymer and the like. In terms of simplicity, if the amounts added of the various components are clear, then the value determined using these amounts is preferably employed. The number of terminal portions other than the terminal portions having a crosslinking group represented by formula (1) (namely, the average number per molecule of the polymer) can also be determined in a similar manner using the ratio (molar ratio) of the amount added of the corresponding monomer.

(Structural Unit T2)

In one embodiment, the charge transport polymer may have, in addition to the structural unit T1 described above, a structural unit other than the structural unit T1, namely a structural unit that does not have a crosslinking group represented by formula (1) (hereafter this other structural unit is also referred to as "structural unit T2") as another terminal portion structural unit T. The charge transport polymer may have only one type of structural unit T2, or may have two or more types.

There are no particular limitations on the structural unit T2, which may be selected, for example, from among substituted or unsubstituted aromatic hydrocarbon structures and aromatic heterocyclic structures, and aromatic ring structures containing one or more of these structures. In one embodiment, from the viewpoint of imparting durability without impairing the charge transport properties, the structural unit T2 is preferably a substituted or unsubstituted aromatic hydrocarbon structure, and is more preferably a substituted or unsubstituted benzene structure. Further, the structural unit T2 may have a similar structure to the structural unit L, or may have a different structure. However, when the structural unit T2 has a similar structure to the structural unit L, the structural unit L is converted to a monovalent form to generate the structural unit T2.

Further, in another embodiment, as described below, when the charge transport polymer has another polymerizable functional group in addition to the crosslinking group represented by formula (1), the structural unit T2 may be a structure that has the polymerizable functional group (for example, a polymerizable functional group such as a pyrrolyl group). In those cases where any of the above structures have a substituent, examples of the substituent include the same groups as those described above for the substituent R in relation to the structural unit L.

Specific examples of the structural unit T2 are shown below, but the structural unit T2 is not limited to the following specific examples.

[Chemical formula 9]

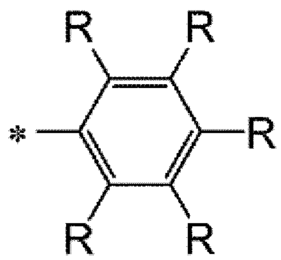

(Structural Unit T2)

In the structural unit T2 of the formula shown above, R is the same as R in the structural unit L (but excluding the cases where the heteroaryl group or heteroarylene group contains the formula (1)). In those cases where the charge transport polymer has another polymerizable functional group at a terminal portion in addition to the crosslinking group represented by formula (1), at least one R is preferably a group containing a polymerizable functional group.

From the viewpoint of imparting favorable curability, the proportion of the structural unit T1 among all the structural units T in the charge transport polymer, based on the total number of all the structural units T, is preferably at

least 1%, more preferably at least 3%, and even more preferably 5% or greater. There are no particular limitations on the upper limit, which may be any number of 100% or less. This proportion among all the structural units T can be determined from the ratio (molar ratio) between the amounts added of the monomers corresponding with the various structural units T during the synthesis of the charge transport polymer.

In those cases where the charge transport polymer has a structural unit T2, from the viewpoint of improving the characteristics of organic electronic elements, the proportion of the structural unit T2 among all the structural units T in the charge transport polymer, based on the total number of all the structural units T, is preferably not more than 99%, more preferably not more than 97%, and even more preferably 95% or less. There are no particular limitations on the lower limit, but if consideration is given to the introduction of polymerizable substituents described below, and the introduction of substituents for the purpose of improving the film formability and the wetting properties and the like, the lower limit is, for example, at least 5%.

(Structural Unit B)

The structural unit B is a trivalent or higher structural unit that forms a branched portion in those cases where the charge transport polymer has a branched structure. From the viewpoint of improving the durability of organic electronic elements, the structural unit B is preferably not higher than hexavalent, and is more preferably either trivalent or tetravalent. The structural unit B is preferably a unit that has charge transport properties. For example, from the viewpoint of improving the durability of organic electronic elements, the structural unit B is preferably selected from among substituted or unsubstituted structures including aromatic amine structures, carbazole structures, condensed polycyclic aromatic hydrocarbon structures, and structures containing one type, or two or more types, of these structures. In those cases where any of the above structures have a substituent, examples of the substituent include the same groups as those described above for the substituent R in relation to the structural unit L.

Specific examples of the structural unit B are shown below. However, the structural unit B is not limited to the following structures.

[Chemical formula 10]

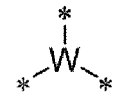
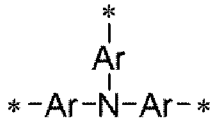
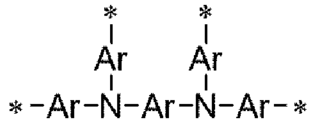
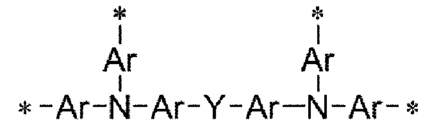
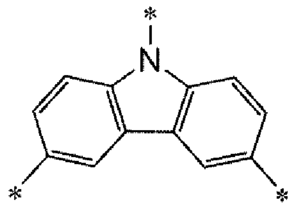
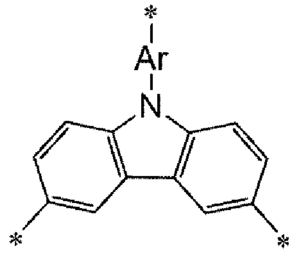
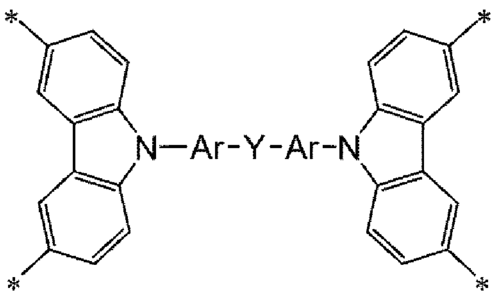
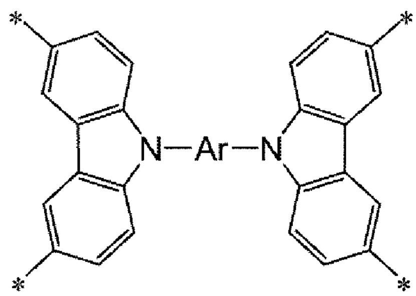
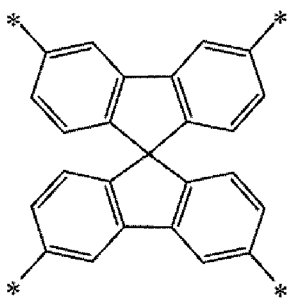
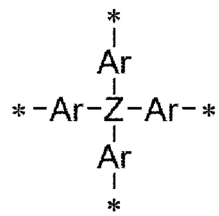
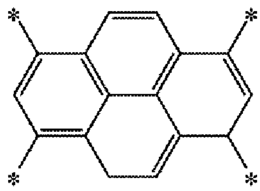

W represents a trivalent linking group, and for example, represents an arenetriyl group or heteroarenetriyl group of 2 to 30 carbon atoms. An arenetriyl group is an atom grouping in which three hydrogen atoms have been removed from an aromatic hydrocarbon. A heteroarenetriyl is an atom grouping in which three hydrogen atoms have been removed from an aromatic heterocycle. Each Ar independently represents a divalent linking group, and for example, may represent an arylene group or heteroarylene group of 2 to 30 carbon atoms. Ar is preferably an arylene group, and is more preferably a phenylene group. Y represents a divalent linking group, and examples include divalent groups in which an additional hydrogen atom has been removed from any of the R groups having one or more hydrogen atoms (but excluding groups containing a polymerizable functional group) described in relation to the structural unit L. Z represents a carbon atom, a silicon atom or a phosphorus atom. In the structural units, the benzene rings and Ar groups may have a substituent, and examples of the substituent include the R groups in the structural unit L.

(Polymerizable Functional Group)

In one embodiment, from the viewpoint of enabling the polymer to be cured by a polymerization reaction, thereby changing the degree of solubility in solvents, the charge transport polymer may have at least one polymerizable functional group besides the structure containing the crosslinking group represented by formula (1). A "polymerizable functional group" refers to a group which is able to form bonds upon the application of heat and/or light. In the following description,

a polymerizable functional group besides the structure containing the crosslinking group represented by formula (1) is termed a polymerizable functional group z.

Examples of the polymerizable functional group z include groups having a carbon-carbon multiple bond (such as a vinyl group, allyl group, butenyl group, ethynyl group, acryloyl group, acryloyloxy group, acryloylamino group, methacryloyl group, methacryloyloxy group, methacryloylamino group, vinyloxy group and vinylamino group), groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and silolyl group). In those cases where a polymerizable functional group z is included, particularly preferred polymerizable functional groups include a vinyl group, acryloyl group, methacryloyl group, epoxy group and oxetane group, and from the viewpoints of improving the reactivity and the characteristics of organic electronic elements, a vinyl group, oxetane group or epoxy group is even more preferred. If consideration is also given to the effects on the charge transport polymer, then in one embodiment, the charge transport polymer does not have a group having a carbon-carbon multiple bond, whereas is another embodiment, the charge transport polymer does not have a polymerizable functional group z.

From the viewpoints of increasing the degree of freedom associated with the polymerizable functional group z and facilitating the polymerization reaction, the main skeleton of the charge transport polymer and the polymerizable functional group z are preferably linked via an alkylene chain. Further, in the case where, for example, an organic layer is to be formed on an electrode, from the viewpoint of enhancing the affinity with hydrophilic electrodes of ITO (Indium Tin Oxide) or the like, the main skeleton and the polymerizable functional group z are preferably linked via a hydrophilic chain such as an ethylene glycol chain or a diethylene glycol chain. Moreover, from the viewpoint of simplifying preparation of the monomer used for introducing the polymerizable functional group z, the charge transport polymer may have an ether linkage or an ester linkage at the terminal of the alkylene chain and/or the hydrophilic chain, namely, at the linkage site between these chains and the polymerizable functional group z, and/or at the linkage site between these chains and the charge transport polymer backbone. The aforementioned "group containing a polymerizable functional group" includes either a polymerizable functional group itself, or a group containing a combination of a polymerizable functional group z and an alkylene chain or the like. Examples of groups that can be used favorably as this group containing a polymerizable functional group z include the groups exemplified in WO 2010/140553.

In those cases where a polymerizable functional group z is introduced, the polymerizable functional group z may be introduced at a terminal portion of the main chain of the charge transport polymer (namely, a structural unit T), at a portion other than a terminal portion of the main chain (namely, a structural unit L or B), or at both a main chain terminal portion and a portion other than a terminal portion. From the viewpoint of the curability, the polymerizable functional group z is preferably introduced at least at a terminal portion of the main chain (namely, a structural unit T), and from the viewpoint of achieving a combination of favorable curability and charge transport properties, is preferably introduced only at main chain terminal portions.

Further, in those cases where the charge transport polymer has a branched structure, the polymerizable functional group z may be introduced in a location other than a terminal portion of the main chain of the charge transport polymer, may be introduced within a side chain, or may be introduced within both a location other than a terminal portion of the main chain and a side chain. From the viewpoint of the curability, the polymerizable functional group z is preferably introduced at least at a terminal portion of the main chain and/or a side chain (namely, a structural unit T), and from the viewpoint of achieving a combination of favorable curability and charge transport properties, is preferably introduced only at terminal portions of the main chain and/or side chains.

From the viewpoint of contributing to a change in the degree of solubility, the polymerizable functional group z is preferably included in the charge transport polymer in a large amount. On the other hand, from the viewpoint of not impeding the charge transport properties, the amount included in the charge transport polymer is preferably kept small. The amount of the polymerizable functional group z may be set as appropriate with due consideration of these factors.

For example, from the viewpoint of obtaining a satisfactory change in the degree of solubility, the number of polymerizable functional groups z per molecule of the charge transport polymer is preferably a number that yields a total, together with the number of crosslinking groups represented by formula (1), of at least 3, and more preferably 4 or greater. Further, from the viewpoint of maintaining good charge transport properties, the number of polymerizable functional groups z is preferably a number that yields a total with the number of crosslinking groups represented by formula (1) of not more than 1,000, and more preferably 500 or fewer.

The total of the number of polymerizable functional groups z and the number of crosslinking group represented by formula (1) per molecule of the charge transport polymer can be determined as an average value using the amount added of the polymerizable functional group z (for example, the amount added of the monomer having the polymerizable functional group), the amount added of the crosslinking group represented by formula (1) (for example, the amount added of the monomer having the crosslinking group represented by formula (1)) and the amounts added of the monomers corresponding with the various structural units during synthesis of the charge transport polymer, and the weight average molecular weight of the charge transport polymer and the like. Further, the total of the number of polymerizable functional

groups z and the number of crosslinking group represented by formula (1) per molecule of the charge transport polymer can also be calculated as an average value using the ratio between the integral of the signals attributable to the crosslinking group represented by formula (1) and the polymerizable functional group z and the integral of the total spectrum in the $^1$H-NMR (nuclear magnetic resonance) spectrum of the charge transport polymer, and the weight average molecular weight of the charge transport polymer and the like. In terms of simplicity, if the amounts added of the various components are clear, then the value determined using these amounts is preferably employed.

(Number Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

(Weight Average Molecular Weight)

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, and even more preferably 400,000 or less.

The number average molecular weight and the weight average molecular weight can be measured by gel permeation chromatography (GPC) under the following conditions, using a calibration curve of standard polystyrenes.
Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 mL/min
Column temperature: room temperature
Molecular weight standards: standard polystyrenes

(Proportions of Structural Units)

From the viewpoint of obtaining satisfactory charge transport properties, the proportion of the structural unit L contained in the charge transport polymer, based on the total of all the structural units, is preferably at least 10 mol%, more preferably at least 20 mol%, and even more preferably 30 mol% or higher. If the structural unit T and the optionally introduced structural unit B are taken into consideration, then the proportion of the structural unit L is preferably not more than 95 mol%, more preferably not more than 90 mol%, and even more preferably 85 mol% or less.

From the viewpoint of improving the characteristics of organic electronic elements, or from the viewpoint of suppressing any increase in viscosity and enabling more favorable synthesis of the charge transport polymer, the proportion of the structural unit T contained in the charge transport polymer, based on the total of all the structural units, is preferably at least 5 mol%, more preferably at least 10 mol%, and even more preferably 15 mol% or higher. Further, from the viewpoint of obtaining satisfactory charge transport properties, the proportion of the structural unit T is preferably not more than 60 mol%, more preferably not more than 55 mol%, and even more preferably 50 mol% or less.

In those cases where the charge transport polymer includes a structural unit B, from the viewpoint of improving the durability of organic electronic elements, the proportion of the structural unit B, based on the total of all the structural units, is preferably at least 1 mol%, more preferably at least 5 mol%, and even more preferably 10 mol% or higher. Further, from the viewpoints of suppressing any increase in viscosity and enabling more favorable synthesis of the charge transport polymer, or from the viewpoint of obtaining satisfactory charge transport properties, the proportion of the structural unit B is preferably not more than 50 mol%, more preferably not more than 40 mol%, and even more preferably 30 mol% or less.

In those cases where the charge transport polymer has a polymerizable functional group z, from the viewpoint of ensuring efficient curing of the charge transport polymer, the proportion of the polymerizable functional group z, expressed as a total together with the proportion of the structural unit containing the functional group represented by formula (1) based on the total of all the structural units, is preferably at least 0.1 mol%, more preferably at least 1 mol%,

and even more preferably 3 mol% or higher. Further, from the viewpoint of obtaining favorable charge transport properties, the proportion of the polymerizable functional group expressed as a total with the proportion of the structural unit containing the functional group represented by formula (1) is preferably not more than 70 mol%, more preferably not more than 60 mol%, and even more preferably 50 mol% or less. Here, the "proportion of the polymerizable functional group z" refers to the proportion of structural units having the polymerizable functional group z.

Further, in those cases where the charge transport polymer does not have a polymerizable functional group z, the proportion of the structural unit containing the crosslinking group represented by formula (1), based on the total of all the structural units, is preferably at least 0.1 mol%, more preferably at least 1 mol%, and even more preferably 3 mol% or higher. Furthermore, the proportion of the structural unit containing the crosslinking group represented by formula (1) is preferably not more than 70 mol%, more preferably not more than 60 mol%, and even more preferably 50 mol% or less.

Considering the balance between the charge transport properties, the durability, and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer also includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the $^1$H-NMR spectrum of the charge transport polymer. In terms of simplicity, if the amount added of the monomer is clear, then the proportion determined using the amount added of the monomer is preferably employed.

When the charge transport polymer is a hole transport material, from the viewpoint of achieving superior hole injection properties and hole transport properties, a compound having a unit having an aromatic amine structure and/or a unit having a carbazole structure as the main structural units is preferred. From this viewpoint, the proportion of the total number of units having an aromatic amine structure and/or units having a carbazole structure relative to the total number of all the structural units within the charge transport polymer (excluding the terminal structural units) is preferably at least 40%, more preferably at least 45%, and even more preferably 50% or greater. This proportion of the total number of units having an aromatic amine structure and/or a units having a carbazole structure may be 100%.

In one preferred embodiment, the charge transport polymer contains at least a divalent structural unit L and a monovalent structural unit T1 containing a crosslinking group represented by formula (1), wherein the structural unit L is at least one type of structural unit selected from the group consisting of structural units that are substituted or unsubstituted aromatic amine structures and structural units that are unsubstituted or unsubstituted carbazole structures, the structural unit T1 is a structural unit that is at least one type of structure selected from the group consisting of structures represented by formula (1) and substituted or unsubstituted aromatic ring structures to which a crosslinking group represented by formula (1) is bonded via a divalent organic group, and the divalent organic group is a group containing at least one group selected from the group consisting of aliphatic organic groups and substituted or unsubstituted aromatic organic groups. The charge transport polymer may also contain at least one type of structural unit selected from the group consisting of trivalent or higher structural units B and monovalent structural units T2 that do not have a crosslinking group represented by formula (1), wherein the structural unit B is preferably a structural unit that is at least one type of structure selected from the group consisting of substituted or unsubstituted aromatic amine structures, substituted or unsubstituted carbazole structures and substituted or unsubstituted condensed polycyclic aromatic hydrocarbon structures, and the structural unit T2 is preferably a structural unit that is a substituted or unsubstituted aromatic ring structure.

(Production Method)

The charge transport polymer can be produced by various synthesis methods, and there are no particular limitations. A method that is capable of bonding together adjacent structural units via a single bond between a carbon atom on an aromatic ring of one structural unit and a carbon atom on an aromatic ring of the other structural unit is preferred. For example, conventional coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymer.

[Dopant]

The organic electronic material may also contain a dopant. There are no particular limitations on the dopant, provided it is a compound that yields a doping effect upon addition to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant.

To improve the hole transport properties, p-type doping is preferably used, whereas to improve the electron transport properties, n-type doping is preferably used. The dopant used in the organic electronic material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as $FeCl_3$, $PF_5$, $AsF_5$, $SbF_5$, $BF_5$, $BCl_3$ and $BBr_3$; protonic acids, including inorganic acids such as HF, HCl, HBr, $HNO_5$, $H_2SO_4$ and $HClO_4$, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, $TiCl_4$, $ZrCl_4$, $HfCl_4$, $NbF_5$, $AlCl_3$, $NbCl_5$, $TaCl_5$ and $MoF_5$; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, $AsF_6^-$ (hexafluoroarsenate ion), $BF_4^-$ (tetrafluoroborate ion) or $PF_6^-$ (hexafluorophosphate ion), and salts having a conjugate base of an aforementioned protonic acid as an anion; halogen compounds such as $Cl_2$, $Br_2$, $I_2$, ICl, $ICl_3$, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples include alkali metals such as Li and Cs; alkaline earth metals such as Mg and Ca; salts of alkali metals and/or alkaline earth metals such as LiF and $Cs_2CO_3$; metal complexes; and electron-donating organic compounds.

In order to make it easier to change the degree of solubility of the organic layer, the use of a compound that can function as a polymerization initiator for the polymerizable functional group as the dopant is preferred. Examples of materials that combine a function as a dopant and a function as a polymerization initiator include the ionic compounds described above.

[Other Optional Components]

The organic electronic material may also include other polymers or the like.

[Contents]

From the viewpoint of obtaining favorable charge transport properties, the amount of the charge transport polymer or oligomer, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

[Polymerization Initiator]

The organic electronic material of an embodiment of the present invention undergoes a satisfactory polymerization reaction even when the material does not include a polymerization initiator, but a polymerization initiator may also be added if required. In those cases where a polymerization initiator is included, a conventional radical polymerization initiator, cationic polymerization initiator, or anionic polymerization initiator or the like may be used. From the viewpoint of simplifying preparation of ink compositions, the use of a material that combines a function as a dopant and a function as a polymerization initiator is preferred. Examples of polymerization initiators that also exhibit a function as a dopant

include the ionic compounds described above. Examples of the ionic compound include salts having a perfluoro anion, and specific examples include salts of a perfluoro anion and an iodonium or ammonium ion (for example, the compounds shown below).

[Chemical formula 11]

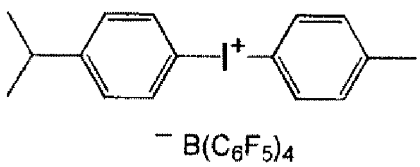

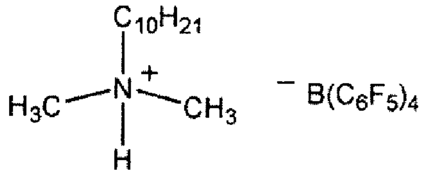

In those cases where the organic electronic material of an embodiment of the present invention contains a polymerization initiator, the amount of the polymerization initiator, based on the mass of the polymer, is preferably from 0.1 to 10.0% by mass, more preferably from 0.2 to 5.0% by mass, and even more preferably from 0.5 to 3.0% by mass.

<Ink Composition>

The organic electronic material may be used in the form of an ink composition containing the organic electronic material of the embodiment described above and a solvent capable of dissolving or dispersing the material. By using the ink composition, an organic layer can be formed easily using a simple coating method.

[Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

[Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

[Contents]

The amount of the solvent in the ink composition can be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

<Organic Layer>

An organic layer according to an embodiment of the present invention is a layer formed using the organic electronic material of the embodiment described above. The organic electronic material of the above embodiment may be used in the form of an ink composition. By using an ink composition, the organic layer can be formed favorably by a coating method. Examples of the coating method include conventional methods such as spin coating methods, casting

methods, dipping methods, plate-based printing methods such as relief printing, intaglio printing, offset printing, lithographic printing, relief reversal offset printing, screen printing and gravure printing, and plateless printing methods such as inkjet methods. When the organic layer is formed by a coating method, the organic layer (coating layer) obtained following coating may be dried using a hot plate or an oven to remove the solvent.

The degree of solubility of the organic layer may be changed by using light irradiation or a heat treatment or the like to cause a polymerization reaction of the charge transport polymer or oligomer. By stacking organic layers having changed degrees of solubility, multilayering of an organic electronic element can be performed with ease. There are no particular limitations on the means used for initiating or progressing the polymerization reaction, and any means that enables a polymerizable substituent to undergo polymerization may be used, including application of heat, light, microwaves, other radiation, or an electron beam or the like. Light irradiation and/or a heat treatment is preferred, and a heat treatment is particularly desirable. In the case of light irradiation, the conditions are preferably set to ensure that the insolubilization reaction proceeds satisfactorily, and the irradiation is, for example, performed for at least 0.1 seconds, but preferably for not more than 10 hours. The heat treatment preferably involves heating at a temperature at least as high as the boiling point of the solvent used in the charge transport layer composition (ink composition), provided the effects of the present invention are not significantly impaired. In the heating step, heating is preferably performed at a temperature of at least 120°C but not more than 410°C, more preferably at a temperature of at least 125°C but mot more than 350°C, and even more preferably at a temperature of at least 130°C but not more than 250°C. Reference may also be made to WO 2010/140553 in relation to the method used for forming the organic layer.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

The organic layer in an embodiment of the present invention is suitable for use as a lower layer beneath a layer that is formed by a coating method. By applying an ink composition to an organic layer of an embodiment of the present invention, an upper layer can be formed favorably without dissolving the lower organic layer.

<Organic Electronic Element>

An organic electronic element that represents one embodiment of the present invention has at least one layer of the organic layer of the embodiment described above. Examples of the organic electronic element include an organic EL element, an organic photoelectric conversion element, and an organic transistor. The organic electronic element preferably has at least a structure in which an organic layer is disposed between a pair of electrodes (an anode and a cathode). Further, in a preferred embodiment, the organic electronic element has at least one layer of the organic layer of the embodiment described above, and one other organic layer that is formed on top of, and contacts, said one layer, wherein the other organic layer is a layer that is formed by a coating method.

[Organic EL Element]

An organic EL element that represents one embodiment of the present invention has at least one layer of the organic layer of the embodiment described above. The organic EL element typically includes a substrate, an anode, a light-emitting layer and a cathode, and if necessary, may also have other functional layers such as a hole injection layer, electron injection layer, hole transport layer and electron transport layer (and if necessary, an additional electron injection layer). Each layer may be formed by a vapor deposition method, or by a coating method. The organic EL element preferably has the organic layer as the light-emitting layer or as another functional layer, more preferably has the organic layer as a functional layer, and even more preferably has the organic layer as at least one of a hole injection layer and a hole transport layer.

FIG. 1 is a cross-sectional schematic view illustrating one embodiment of the organic EL element. The organic EL element in FIG. 1 is an element with a multilayer structure, and has a substrate 8, an anode 2, a hole injection layer 3 and a hole transport layer 6 each formed from an organic layer of the embodiment described above, a light-emitting layer 1, an electron transport layer 7, an electron injection layer 5 and a cathode 4 provided in that order. Each of these layers is described below.

In FIG. 1, the hole injection layer 3 and the hole transport layer 6 are organic layers formed using the organic electronic material described above, but the organic EL element of an embodiment of the present invention is not limited to this type of structure, and another organic layer may be an organic layer formed using the organic electronic material described above.

Examples of organic electroluminescent elements are described below.

- An organic electroluminescent element formed by stacking at least a substrate, an anode, a light-emitting layer and

a cathode, wherein the light-emitting layer is an organic layer of the embodiment described above.

- An organic electroluminescent element formed by stacking at least a substrate, an anode, a hole injection layer, a hole transport layer, a light-emitting layer and a cathode, wherein at least one of the hole injection layer, the hole transport layer and the light-emitting layer is an organic layer of the embodiment described above.
- An organic electroluminescent element formed by stacking at least a substrate, an anode, a hole injection layer, a hole transport layer, a light-emitting layer, an electron transport layer, an electron injection layer and a cathode, wherein at least one of the hole injection layer, the hole transport layer, the light-emitting layer, the electron transport layer and the electron injection layer is an organic layer of the embodiment described above.

[Light-Emitting Layer]

Examples of the materials that can be used for the light-emitting layer include low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,$C^2$]picolinate) which emits blue light, $Ir(ppy)_3$ (fac-tris(2-phenylpyridine)iridium) which emits green light, and $(btp)_2Ir(acac)$ (bis[2-(2'-benzo[4,5-$\alpha$]thienyl)pyridinato-N,$C^3$]iridium(acetyl-acetonate)) and $Ir(piq)_3$ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material of the embodiment described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

[Hole Transport Layer, Hole Injection Layer]

In FIG. 1, the hole injection layer 3 and the hole transport layer 6 are organic layers formed using the organic electronic material described above, but the organic EL element of an embodiment of the present invention is not limited to this type of structure, and one or more other organic layers may be formed using the organic electronic material described above. The organic layer formed using the organic electronic material described above is preferably used as at least one of a hole transport layer and a hole injection layer, and is more preferably used as at least a hole transport layer. For example, in those cases where the organic EL element has a layer formed using the organic electronic material described above as a hole transport layer, and also has a hole injection layer, a conventional material may be used for the hole injection layer. Further, in those cases where the organic EL element has an organic layer formed using the organic electronic material described above as a hole injection layer, and also has a hole transport layer, a conventional material may be used for the hole transport layer.

Examples of materials that can be used for the hole injection layer and the hole transport layer include aromatic amine-based compounds (for example, aromatic diamines such as N,N'-di(naphthalen-1-yl)-N,N'-diphenyl-benzidine ($\alpha$-NPD)), phthalocyanine-based compounds, and thiophene-based compounds (for example, thiophene-based conductive polymers (such as poly(3,4-ethylenedioxythiophene):poly(4-styrenesulfonate) (PEDOT:PSS) and the like).

[Electron Transport Layer, Electron Injection Layer]

Examples of materials that can be used for the electron transport layer and the electron injection layer include

phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives (for example, 2,2',2"-(1,3,5-benzenetriyl)tris(1-phenyl-1H-benzimidazole) (TPBi)), quinoxaline derivatives, and aluminum complexes (for example, aluminum bis(2-methyl-8-quinolinolate)-4-(phenylphenolate) (BAlq)). Further, the organic electronic material of the embodiment described above may also be used.

[Cathode]

Examples of the cathode material include metals or metal alloys, such as Li, Ca, Mg, Al, In, Cs, Ba, Mg/Ag, LiF and CsF.

[Anode]

Metals (for example, Au) or other materials having conductivity can be used as the anode. Examples of the other materials include oxides (for example, ITO: indium oxide/tin oxide, and conductive polymers (for example, polythiophene-polystyrene sulfonate mixtures (PEDOT:PSS)).

[Substrate]

Glass and plastics and the like can be used as the substrate. The substrate is preferably transparent, and a substrate having flexibility is preferred. Quartz glass and light-transmitting resin films and the like can be used particularly favorably.

Examples of the resin films include films containing polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

[Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or for yellowish green and orange or the like. Control of the emission color can be achieved by appropriate adjustment of the types and amounts of the light-emitting materials.

[Display Element, Illumination Device, Display Device]

A display element that represents one embodiment of the present invention contains the organic EL element of the embodiment described above. For example, by using the organic EL element as the element corresponding with each color pixel of red, green and blue (RGB), a color display element can be obtained. Examples of the image formation method include a simple matrix in which organic EL elements arrayed in a panel are driven directly by an electrode arranged in a matrix, and an active matrix in which a thin-film transistor is positioned on, and drives, each element.

Further, an illumination device that represents one embodiment of the present invention contains the organic EL element of an embodiment of the present invention. Moreover, a display device according to one embodiment of the present invention contains the illumination device and a liquid crystal element as a display unit. For example, the display device may be a device that uses the illumination device of an embodiment of the present invention as a backlight, and uses a conventional liquid crystal element as the display unit, namely a liquid crystal display device.

Examples

[Synthesis Examples]

Synthesis examples of monomers having a crosslinking group represented by formula (1) are described below, but the present invention is not limited to the following synthesis examples.

(Synthesis Example 1)

A monomer T1-2 having the structure shown below was synthesized using the method described below. Specifically, synthesis was performed using the sequence shown below.

[Chemical formula 12]

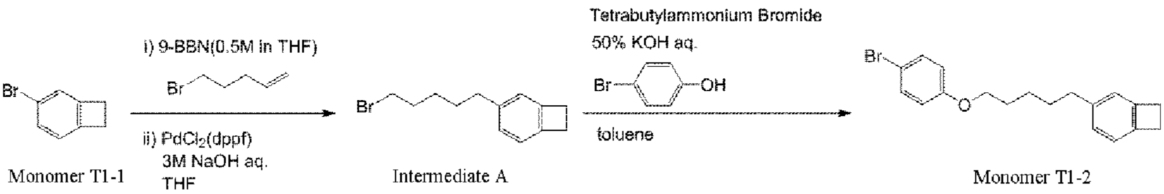


In a 300 mL three-neck flask under a nitrogen atmosphere, 5-bromo-1-pentene (7.45 g, 50 mmol) and THF (20 ml) were mixed together, a 0.5 M 9-BBN/THF solution (100 ml) was added dropwise to the resulting solution over a period of one hour, and the resulting mixture was stirred at room temperature for 12 hours. A monomer T1-1 (3.66 g, 20 mmol), ((diphenylphosphino)ferrocene)palladium dichloride (0.82 g), and a mixture of THF (32 ml) and a 3 M aqueous solution of sodium hydroxide (27 ml) were mixed with the thus obtained reaction solution and refluxed for 4 hours. Following completion of the reaction, the obtained solution was cooled to room temperature, hexane (40 ml) was added, and with the resulting solution cooled in an ice bath, hydrogen peroxide water (6 ml) was added gradually to the flask in a dropwise manner, and the resulting mixture was then stirred for one hour. The reaction mixture was then separated, and the organic layer was washed 5 times with ion-exchanged water (50 ml). The thus obtained organic layer was dried over sodium sulfate, and then purified by column chromatography using a silica gel filler and using hexane as the eluent, thus obtaining an intermediate A (3.80 g, 15 mmol).

In a 50 ml two-neck flask under a nitrogen atmosphere, the intermediate A (3.80 g, 15 mmol), 4-bromophenol (3.89 g, 22.5 mmol), tetrabutylammonium bromide (0.16 g, 0.5 mmol), a 50% aqueous solution of potassium hydroxide (6.7 g) and toluene (20 ml) were mixed together and then refluxed for 6 hours. Following completion of the reaction, the obtained solution was washed 3 times with ion-exchanged water (10 ml). The resulting organic layer was dried over sodium sulfate, and then purified by column chromatography using a silica gel filler and using a mixed solvent of hexane/ethyl acetate (95/5) as the eluent, thus obtaining a monomer T1-2 (4.14 g, 12 mmol).

(Synthesis Example 2)

A monomer T1-3 having the structure shown below was synthesized using the method described below. Specifically, synthesis was performed using the sequence shown below.

[Chemical formula 13]

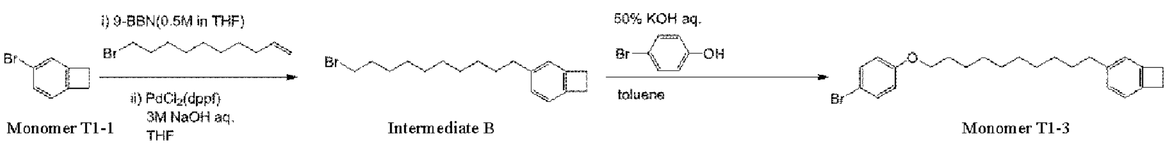


With the exception of using 10-bromo-1-decene (10.96 g, 50 mmol) instead of the 5-bromo-1-pentene (7.45 g, 50 mmol), synthesis was conducted using the same procedure as Synthesis Example 1, yielding an intermediate B (4.53 g, 14 mmol).

With the exception of using the intermediate B (4.53 g, 14 mmol) instead of the intermediate A (3.80 g, 15 mmol) and adjusting the equivalence ratio, synthesis was conducted using the same procedure as above, yielding a monomer T1-3 (4.99 g, 12 mmol).

(Synthesis Example 3)

A monomer T1-4 having the structure shown below was synthesized using the method described below. Specifically, synthesis was performed using the sequence shown below.

[Chemical formula 14]

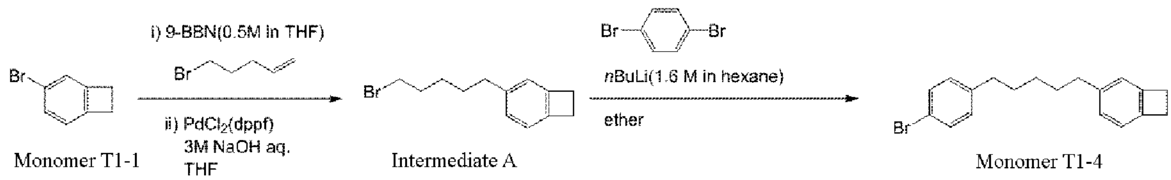


Monomer T1-1 Intermediate A Monomer T1-4

The intermediate A (3.80 g, 15 mmol) was obtained in the same manner as Synthesis Example 1.

In a 200 mL three-neck flask under a nitrogen atmosphere, 1,4-dibromobenzene (3.54 g, 15 mmol) and ether (30 ml) were mixed together, the obtained solution was cooled to -78°C, a 1.6 M hexane solution of n-butyllithium (9.4 ml) was added dropwise over a period of 30 minutes, and the resulting mixture was then stirred at -78°C for two hours. Subsequently, the intermediate A (3.80 g, 15 mmol) was added in a dropwise manner and stirred at -78°C for 30 minutes. Subsequently, the temperature was returned to room temperature, and stirring was continued for 12 hours. The obtained mixture was separated, and the resulting organic layer was dried over sodium sulfate and then purified by column chromatography using a silica gel filler and using hexane as the eluent, thus obtaining a monomer T1-4 (2.96 g, 9 mmol).

(Synthesis Example 4)

A monomer T1-5 having the structure shown below was synthesized using the method described below. Specifically, synthesis was performed using the sequence shown below.

[Chemical formula 15]

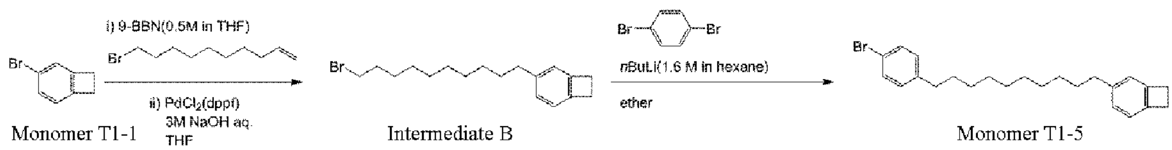


Monomer T1-1 Intermediate B Monomer T1-5

With the exception of using the intermediate B (4.99 g, 12 mmol) instead of the intermediate A (3.80 g, 15 mmol) and adjusting the equivalence ratio, synthesis was conducted using the same procedure as Synthesis Example 3, yielding a monomer T1-5 (2.40 g, 6 mmol).

(Synthesis Example 5)

A monomer L-4 having the structure shown below was synthesized using the method described below. Specifically, synthesis was performed using the sequence shown below.

[Chemical formula 16]

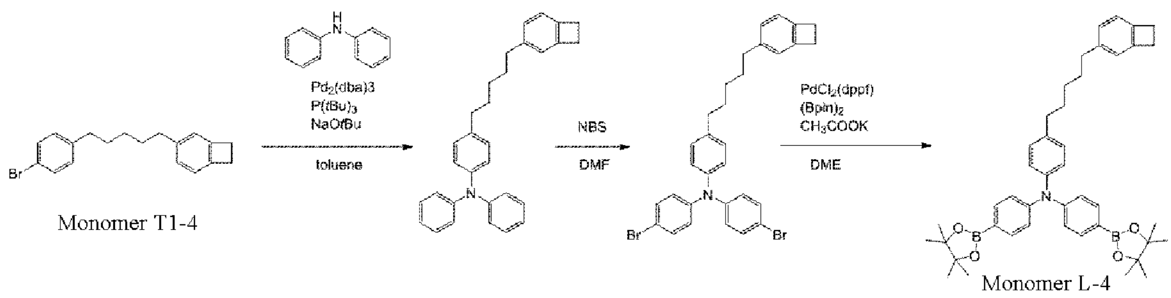


Monomer T1-4

Monomer L-4

In a 200 mL three-neck flask under a nitrogen atmosphere, the monomer T1-4 (5.69 g, 17.3 mmol), diphenylamine (2.92 g, 17.3 mmol), tris(dibenzylideneacetone) dipalladium (0.37 g, 0.4 mmol), tri-t-butylphosphine (0.32 g, 1.6 mmol), sodium t-butoxide (3.8 g, 40 mmol) and toluene (100 ml) were mixed together and then stirred at 110°C for 6 hours. Subsequently, the obtained mixture was separated, the resulting organic layer was dried over sodium sulfate and then purified by column chromatography using a silica gel filler and using a mixed solvent of hexane/ethyl acetate as the eluent, and a conventional bromination and boronization were then performed to obtain a monomer L-4 (6.03 g, 9 mmol).

[Examples]

The present invention is described below in further detail using a series of examples, but the present invention is not limited by the following examples. Unless specifically stated otherwise, "%" means "% by mass".

<Preparation of Pd Catalyst>

In a glove box under a nitrogen atmosphere and at room temperature, tris(dibenzylideneacetone)dipalladium (73.2 mg, 80 μmol) was weighed into a sample tube, anisole (15 ml) was added, and the resulting mixture was agitated for 30 minutes. In a similar manner, tris(t-butyl)phosphine (129.6 mg, 640 μmol) was weighed into a sample tube, anisole (5 ml) was added, and the resulting mixture was agitated for 5 minutes. The two solutions were then mixed together and stirred for 30 minutes at room temperature to obtain a catalyst. All the solvents used in the catalyst preparation were deaerated by nitrogen bubbling for at least 30 minutes prior to use.

<Synthesis of Charge Transport Polymer 1>

A three-neck round-bottom flask was charged with a monomer L-1 shown below (5.0 mmol), a monomer B-1 shown below (2.0 mmol), a monomer T2-1 shown below (2.0 mmol), a monomer T2-2 shown below (2.0 mmol) and anisole (20 mL), and the prepared Pd catalyst solution (7.5 mL) was then added. After stirring for 30 minutes, a 10% aqueous solution of tetraethylammonium hydroxide (20 mL) was added. All of the solvents were deaerated by nitrogen bubbling for at least 30 minutes prior to use. The resulting mixture was heated and refluxed for two hours. All the operations up to this point were conducted under a stream of nitrogen.

[Chemical formula 17]

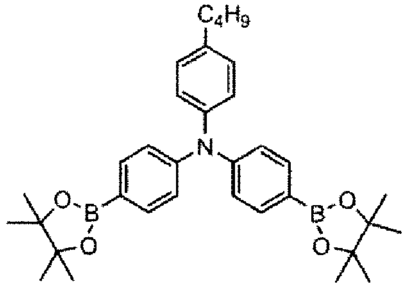

Monomer L-1

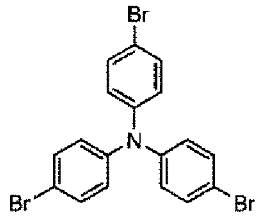

Monomer B-1

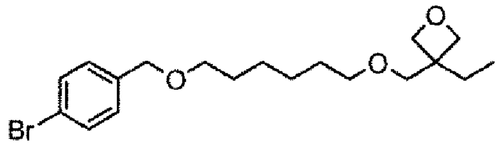

Monomer T2-1

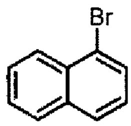

Monomer T2-2

After completion of the reaction, the organic layer was washed with water and then poured into methanol-water (9:1). The resulting precipitate was collected by filtration under reduced pressure, and washed with methanol-water (9:1). The thus obtained precipitate was dissolved in toluene, and re-precipitated from methanol. The obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1.

The thus obtained charge transport polymer 1 had a number average molecular weight of 5,200 and a weight average molecular weight of 41,200. The charge transport polymer 1 had a structural unit L-1, a structural unit B-1, a structural unit T2-2, and a structural unit T2-1 having an oxetane group, and the proportions (molar ratios) of those structural units were 45.5%, 18.2%, 18.2% and 18.2% respectively. The charge transport polymer 1 had a multi-branched structure. The charge transport polymer 1 did not have a terminal portion having a crosslinking group represented by formula (1). The structure is shown in the following formula. (The various structural units are shown in parentheses on the left, with the appended numbers indicating the molar ratios of the various repeating units. A partial structure of the linked polymer is shown on the right. The same layout is used for charge transport polymers 2 to 8 described below.)

[Chemical formula 18]

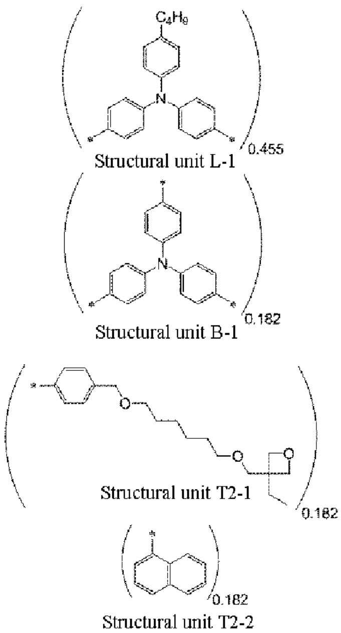

Structural unit L-1

Structural unit B-1

Structural unit T2-1

Structural unit T2-2

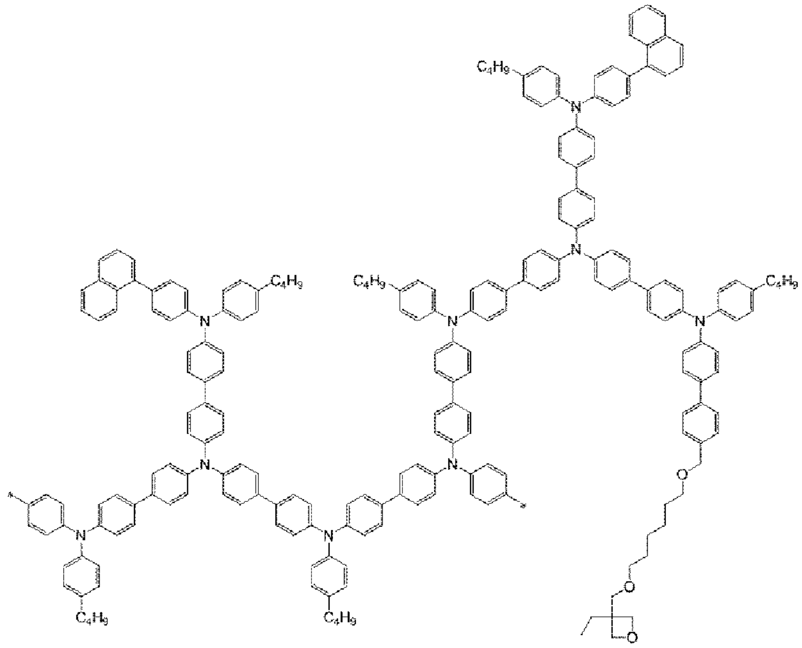

The number average molecular weight and the weight average molecular weight was measured by GPC (relative to polystyrene standards) using tetrahydrofuran (THF) as the eluent. The measurement conditions were as follows.

Feed pump: L-6050, manufactured by Hitachi High-Technologies Corporation

UV-Vis detector: L-3000, manufactured by Hitachi High-Technologies Corporation

Columns: Gelpack (a registered trademark) GL-A160S / GL-A150S, manufactured by Hitachi Chemical Co., Ltd.

Eluent: THF (for HPLC, stabilizer-free), manufactured by Wako Pure Chemical Industries, Ltd.

Flow rate: 1 mL/min

Column temperature: room temperature

Molecular weight standards: standard polystyrenes

<Synthesis of Charge Transport Polymer 2>

A three-neck round-bottom flask was charged with the monomer L-1 shown above (5.0 mmol), a monomer B-2 shown below (2.0 mmol), a monomer T1-1 shown below (2.0 mmol), a monomer T2-3 shown below (2.0 mmol) and anisole (20 mL), and the prepared Pd catalyst solution (7.5 mL) was then added. Thereafter, a charge transport polymer 2 was synthesized in the same manner as the synthesis of the charge transport polymer 1.

[Chemical formula 19]

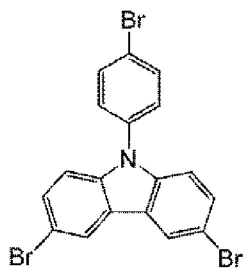

Monomer B-2

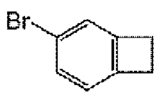

Monomer T1-1

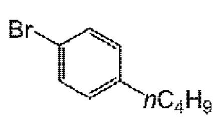

Monomer T2-3

The thus obtained charge transport polymer 2 had a number average molecular weight of 10,600 and a weight average molecular weight of 66,400. The charge transport polymer 2 had a structural unit L-1, a structural unit B-2, a structural unit T1-1, and a structural unit T2-3, and the proportions (molar ratios) of those structural units were 45.5%,

18.2%, 18.2% and 18.2% respectively. The charge transport polymer 2 had a multi-branched structure. In the charge transport polymer 2, the number of terminal portions having a crosslinking group represented by formula (1) (the average number per molecule of the polymer) was 54 (calculated from the amounts added of the monomers), which represented 50% of the total of all the structural units T.

Specifically, the number of terminal portions having a crosslinking group represented by formula (1) (the structural unit T1-1 in this case) was calculated in the following manner.

First, the number of structural units T1-1 was deemed x, meaning the proportions (molar ratios) of the structural units were B-2: x, T1-1: x, T2-3: x, and L-1: 2.5x.

Next, by using the molecular weights of the various structural units, L-1: 299.42 g/mol, B-2: 240.29 g/mol, T1-1: 103.14 g/mol and T2-3: 133.21 g/mol, and the weight average molecular weight of 66,400, solving the following equation:

$$299.42(2.5x) + 240.29x + 103.14x + 133.21x = 66{,}400$$

yielded a result of x = 54 (with normal rounding after the decimal point) (the same method was used for the subsequent charge transport polymers 3 to 9, 12 and 13).

The structure is shown in the formula below.

[Chemical formula 20]

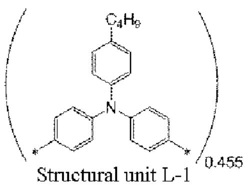
Structural unit L-1

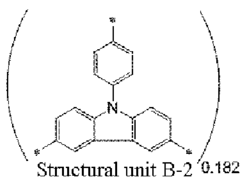
Structural unit B-2

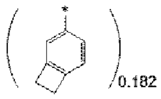
Structural unit T1-1

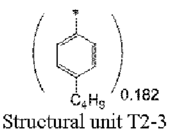
Structural unit T2-3

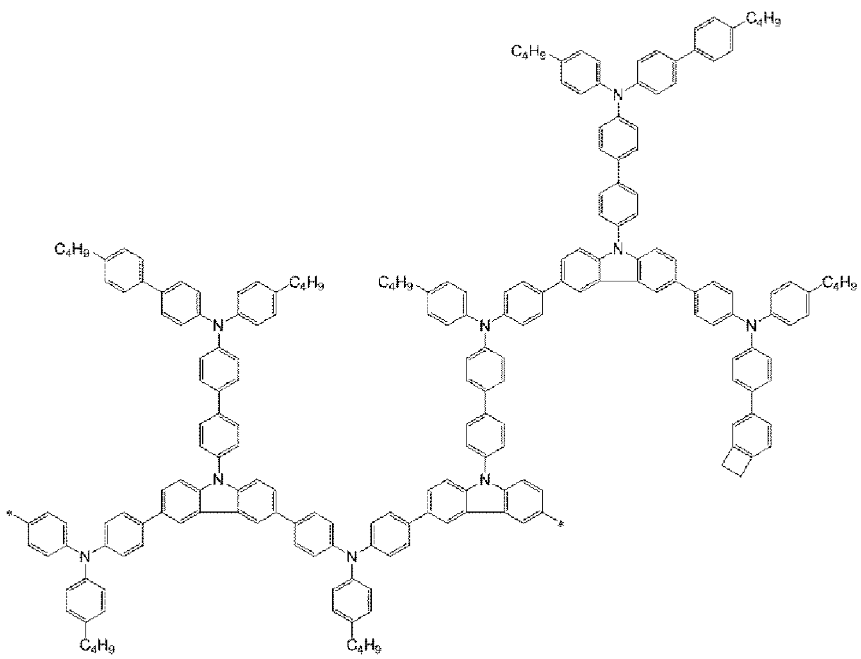

<Synthesis of Charge Transport Polymer 3>

A three-neck round-bottom flask was charged with the monomer L-1 shown above (5.0 mmol), the monomer B-2 shown above (2.0 mmol), a monomer T1-2 shown below (2.0 mmol), the monomer T2-3 shown above (2.0 mmol) and anisole (20 mL), and the prepared Pd catalyst solution (7.5 mL) was then added. Thereafter, a charge transport polymer 3 was synthesized in the same manner as the synthesis of the charge transport polymer 1.

[Chemical formula 21]

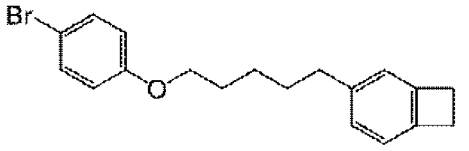

Monomer T1-2

The thus obtained charge transport polymer 3 had a number average molecular weight of 15,600 and a weight average molecular weight of 67,600. The charge transport polymer 3 had a structural unit L-1, a structural unit B-2, a structural unit T1-2, and a structural unit T2-3, and the proportions (molar ratios) of those structural units were 45.5%, 18.2%, 18.2% and 18.2% respectively. The charge transport polymer 3 had a multi-branched structure. In the charge transport polymer 3, the number of terminal portions having a crosslinking group represented by formula (1) (the structural unit T1-2 in this case) (the average number per molecule of the polymer) was 49 (calculated from the amounts added of the monomers), which represented 50% of the total of all the structural units T. The structure is shown in the formula below.

[Chemical formula 22]

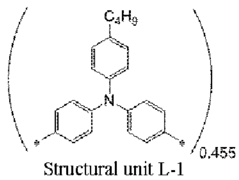

Structural unit L-1

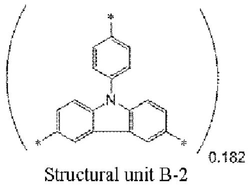

Structural unit B-2

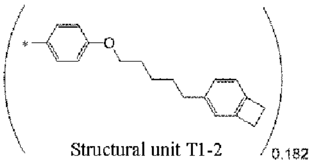

Structural unit T1-2

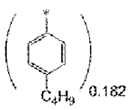

Structural unit T2-3

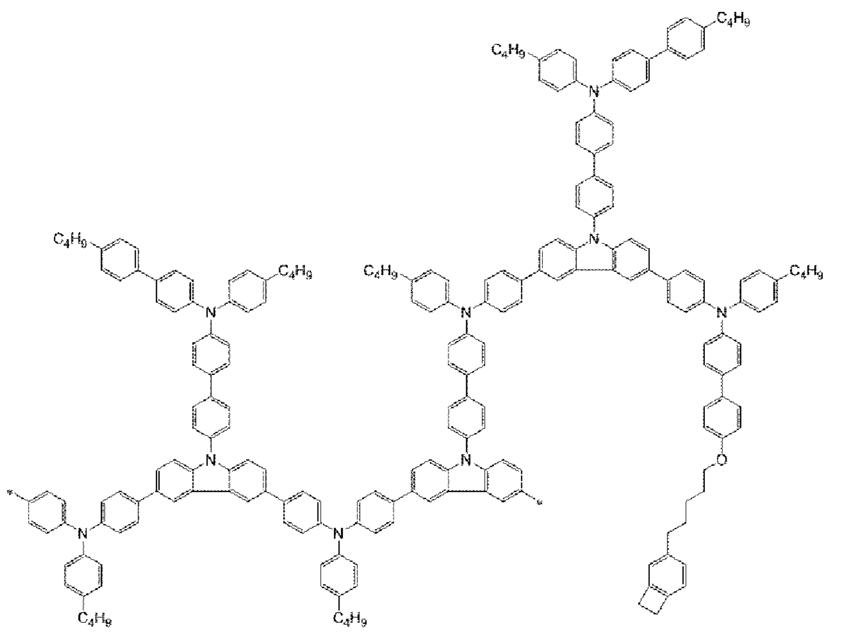

<Synthesis of Charge Transport Polymer 4>

A three-neck round-bottom flask was charged with the monomer L-1 shown above (5.0 mmol), the monomer B-2 shown above (2.0 mmol), a monomer T1-3 shown below (2.0 mmol), the monomer T2-3 shown above (2.0 mmol) and anisole (20 mL), and the prepared Pd catalyst solution (7.5 mL) was then added. Thereafter, a charge transport polymer 4 was synthesized in the same manner as the synthesis of the charge transport polymer 1.

[Chemical formula 23]

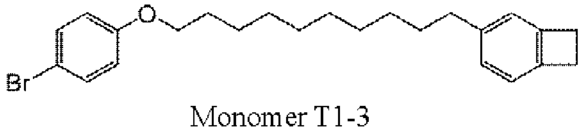

Monomer T1-3

The thus obtained charge transport polymer 4 had a number average molecular weight of 15,300 and a weight average molecular weight of 61,500. The charge transport polymer 4 had a structural unit L-1, a structural unit B-2, a structural unit T1-3, and a structural unit T2-3, and the proportions (molar ratios) of those structural units were 45.5%, 18.2%, 18.2% and 18.2% respectively. The charge transport polymer 4 had a multi-branched structure. In the charge transport polymer 4, the number of terminal portions having a crosslinking group represented by formula (1) (the structural unit T1-3 in this case) (the average number per molecule of the polymer) was 42 (calculated from the amounts added of the monomers), which represented 50% of the total of all the structural units T. The structure is shown in the formula below.

[Chemical formula 24]

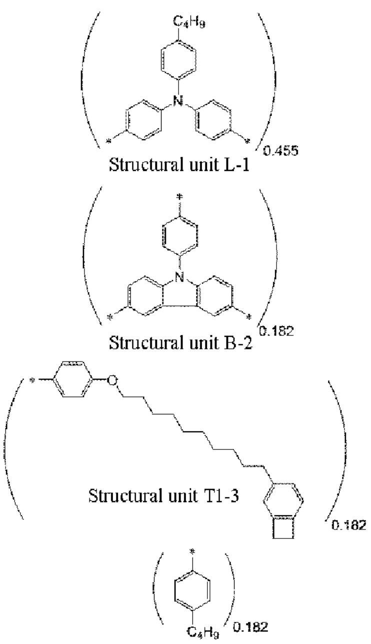

Structural unit L-1

Structural unit B-2

Structural unit T1-3

Structural unit T2-3

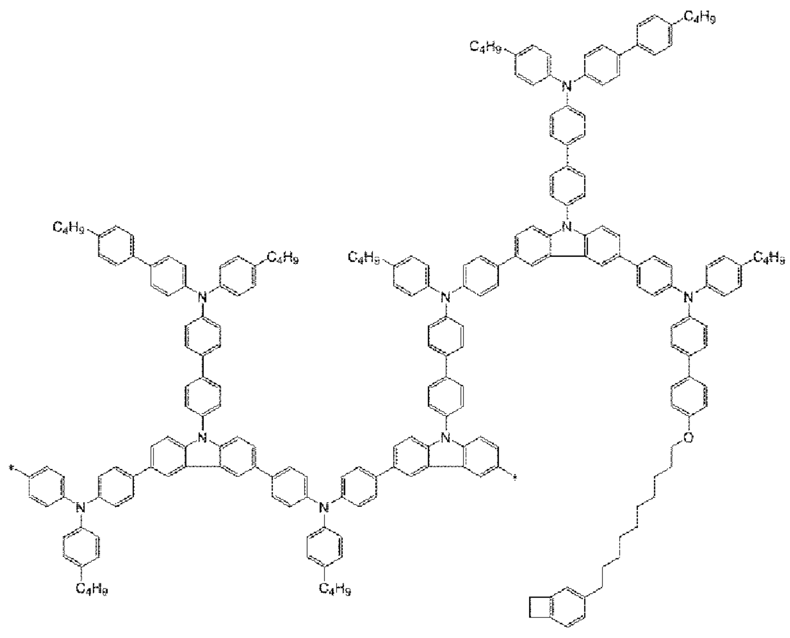

<Synthesis of Charge Transport Polymer 5>

A three-neck round-bottom flask was charged with the monomer L-1 shown above (5.0 mmol), the monomer B-2 shown above (2.0 mmol), a monomer T1-4 shown below (2.0 mmol), the monomer T2-3 shown above (2.0 mmol) and anisole (20 mL), and the prepared Pd catalyst solution (7.5 mL) was then added. Thereafter, a charge transport polymer 5 was synthesized in the same manner as the synthesis of the charge transport polymer 1.

[Chemical formula 25]

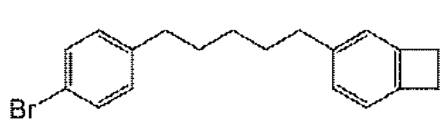

Monomer T1-4

The thus obtained charge transport polymer 5 had a number average molecular weight of 13,500 and a weight average molecular weight of 60,000. The charge transport polymer 5 had a structural unit L-1, a structural unit B-2, a structural unit T1-4, and a structural unit T2-3, and the proportions (molar ratios) of those structural units were 45.5%, 18.2%, 18.2% and 18.2% respectively. The charge transport polymer 5 had a multi-branched structure. In the charge transport polymer 5, the number of terminal portions having a crosslinking group represented by formula (1) (the structural unit T1-4 in this case) (the average number per molecule of the polymer) was 44 (calculated from the amounts added of the monomers), which represented 50% of the total of all the structural units T. The structure is shown in the formula below.

[Chemical formula 26]

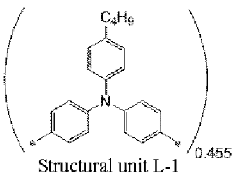

Structural unit L-1

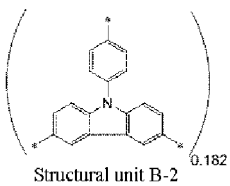

Structural unit B-2

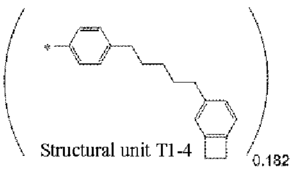

Structural unit T1-4

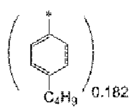

Structural unit T2-3

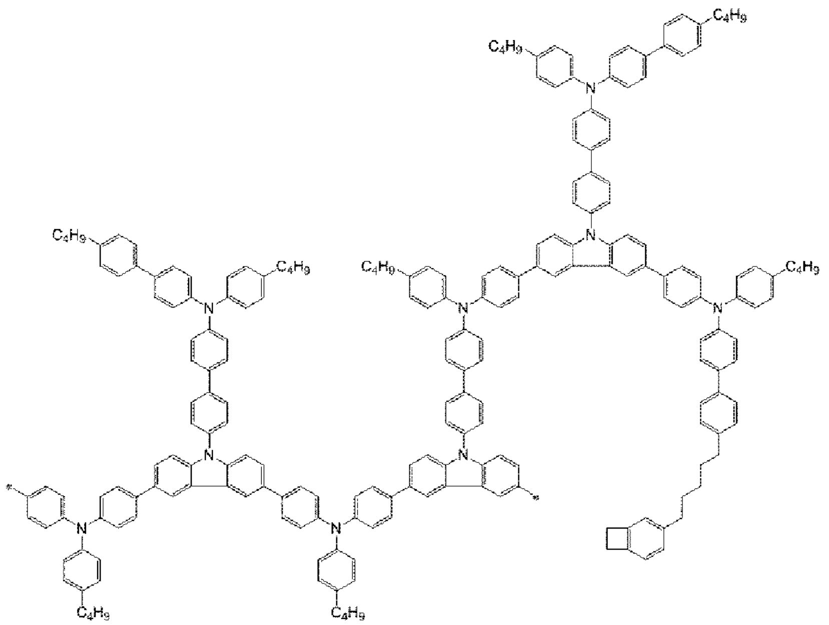

<Synthesis of Charge Transport Polymer 6>

A three-neck round-bottom flask was charged with the monomer L-1 shown above (5.0 mmol), the monomer B-2 shown above (2.0 mmol), a monomer T1-5 shown below (2.0 mmol), the monomer T2-3 shown above (2.0 mmol) and anisole (20 mL), and the prepared Pd catalyst solution (7.5 mL) was then added. Thereafter, a charge transport polymer 6 was synthesized in the same manner as the synthesis of the charge transport polymer 1.

[Chemical formula 27]

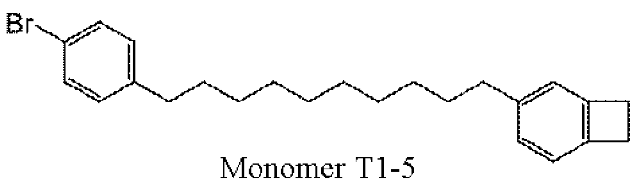

Monomer T1-5

The thus obtained charge transport polymer 6 had a number average molecular weight of 13,500 and a weight average molecular weight of 60,000. The charge transport polymer 6 had a structural unit L-1, a structural unit B-2, a structural unit T1-5, and a structural unit T2-3, and the proportions (molar ratios) of those structural units were 45.5%, 18.2%, 18.2% and 18.2% respectively. The charge transport polymer 6 had a multi-branched structure. In the charge transport polymer 6, the number of terminal portions having a crosslinking group represented by formula (1) (the structural unit T1-5 in this case) (the average number per molecule of the polymer) was 42 (calculated from the amounts added of the monomers), which represented 50% of the total of all the structural units T. The structure is shown in the formula below.

[Chemical formula 28]

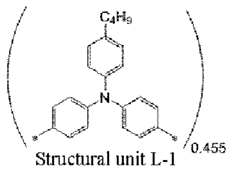

Structural unit L-1

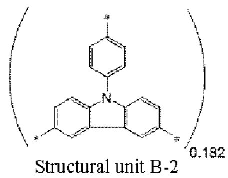

Structural unit B-2

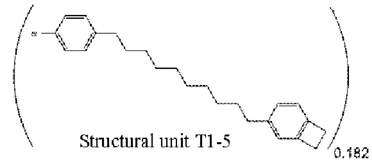

Structural unit T1-5

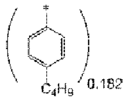

Structural unit T2-3

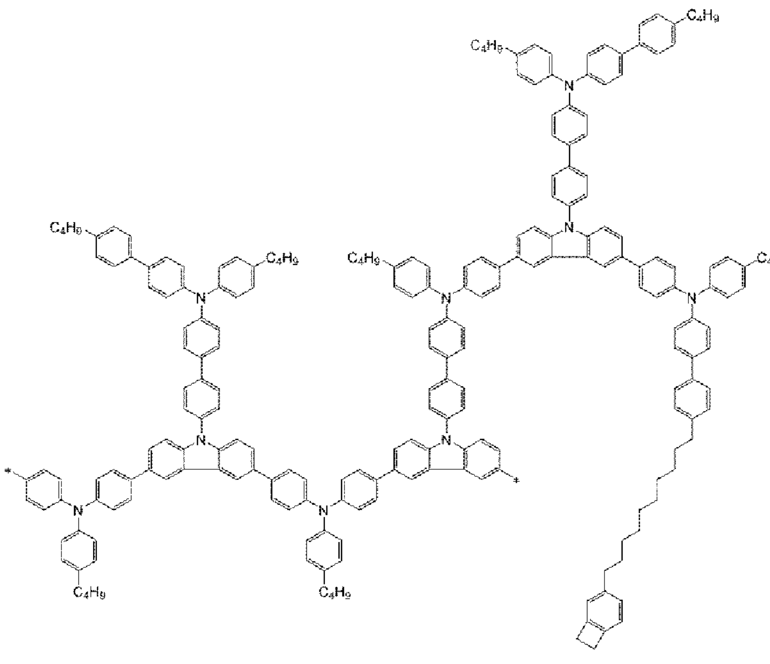

<Synthesis of Charge Transport Polymer 7>

A three-neck round-bottom flask was charged with the monomer L-1 shown above (1.0 mmol), a monomer L-2 shown below (2.0 mmol), a monomer L-3 shown below (2.0 mmol), the monomer B-1 shown above (2.0 mmol), the monomer T1-2 shown above (2.0 mmol), the monomer T2-3 shown above (2.0 mmol) and anisole (20 mL), and the prepared Pd catalyst solution (7.5 mL) was then added. Thereafter, a charge transport polymer 7 was synthesized in the same manner as the synthesis of the charge transport polymer 1.

[Chemical formula 29]

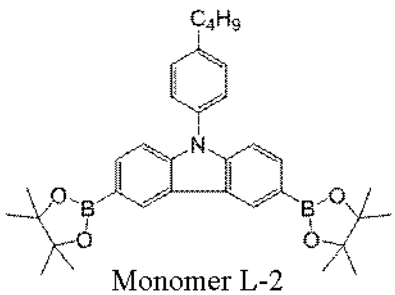

Monomer L-2

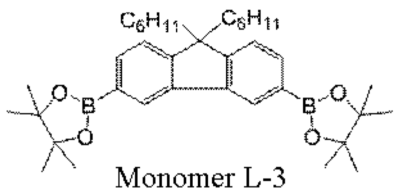

Monomer L-3

The thus obtained charge transport polymer 7 had a number average molecular weight of 14,500 and a weight average molecular weight of 63,900. The charge transport polymer 7 had a structural unit L-1, a structural unit L-2, a structural unit L-3, a structural unit B-1, a structural unit T1-2, and a structural unit T2-3, and the proportions (molar ratios) of those structural units were 9.1%, 18.2%, 18.2%, 18.2%, 18.2% and 18.2% respectively. The charge transport polymer 7 had a multi-branched structure. In the charge transport polymer 7, the number of terminal portions having a crosslinking group represented by formula (1) (the structural unit T1-2 in this case) (the average number per molecule of the polymer) was 45 (calculated from the amounts added of the monomers), which represented 50% of the total of all the structural units T. The structure is shown in the formula below.

[Chemical formula 30]

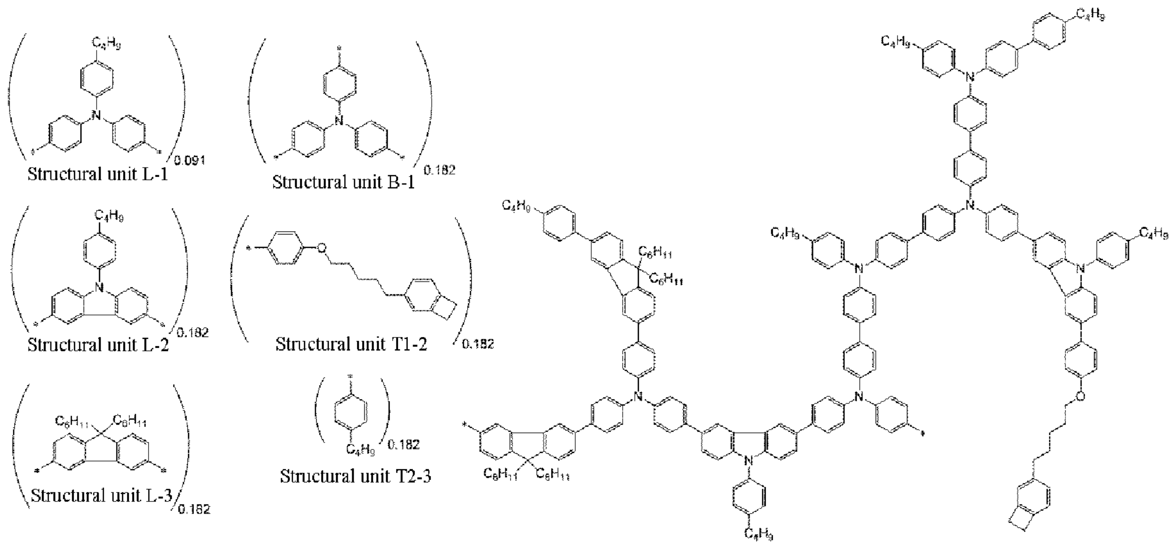

Structural unit L-1 0.091

Structural unit B-1 0.182

Structural unit L-2 0.182

Structural unit T1-2 0.182

Structural unit L-3 0.182

0.182 Structural unit T2-3

<Synthesis of Charge Transport Polymer 8>

A three-neck round-bottom flask was charged with the monomer L-1 shown above (1.0 mmol), the monomer L-2 shown above (2.0 mmol), the monomer L-3 shown above (2.0 mmol), the monomer B-1 shown above (2.0 mmol), the monomer T1-2 shown above (3.2 mmol), the monomer T2-3 shown above (0.8 mmol) and anisole (20 mL), and the prepared Pd catalyst solution (7.5 mL) was then added. Thereafter, a charge transport polymer 8 was synthesized in the same manner as the synthesis of the charge transport polymer 1.

The thus obtained charge transport polymer 8 had a number average molecular weight of 13,500 and a weight average molecular weight of 64,000. The charge transport polymer 8 had a structural unit L-1, a structural unit L-2, a structural unit L-3, a structural unit B-1, a structural unit T1-2, and a structural unit T2-3, and the proportions (molar ratios) of those structural units were 9.1%, 18.2%, 18.2%, 18.2%, 29.1% and 7.3% respectively. The charge transport polymer 8 had a multi-branched structure. In the charge transport polymer 8, the number of terminal portions having a crosslinking group represented by formula (1) (the structural unit T1-2 in this case) (the average number per molecule of the polymer) was 68 (calculated from the amounts added of the monomers), which represented 80% of the total of all the structural units T. The structure is shown in the formula below.

[Chemical formula 31]

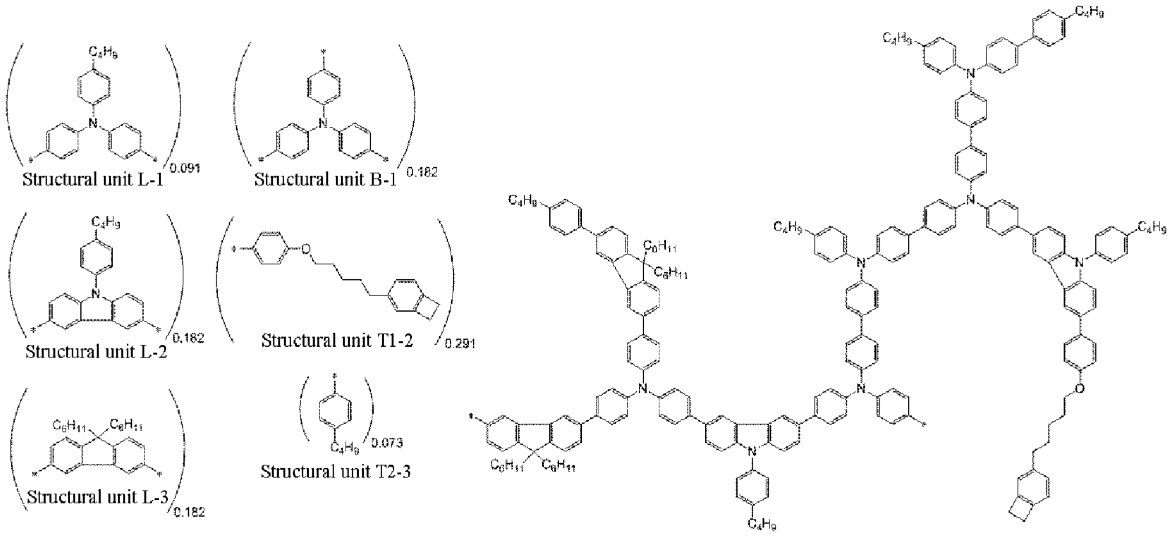

Structural unit L-1

Structural unit B-1

Structural unit L-2

Structural unit T1-2

Structural unit L-3

Structural unit T2-3

<Synthesis of Charge Transport Polymer 9>

A three-neck round-bottom flask was charged with the monomer L-1 shown above (5.0 mmol), the monomer B-2 shown above (2.0 mmol), the monomer T1-2 shown above (3.2 mmol), the monomer T2-3 shown above (0.8 mmol) and anisole (20 mL), and the prepared Pd catalyst solution (7.5 mL) was then added. Thereafter, a charge transport polymer 9 was synthesized in the same manner as the synthesis of the charge transport polymer 1.

The thus obtained charge transport polymer 9 had a number average molecular weight of 16,600 and a weight average molecular weight of 68,200. The charge transport polymer 9 had a structural unit L-1, a structural unit B-2, a structural unit T1-2, and a structural unit T2-3, and the proportions (molar ratios) of those structural units were 45.5%, 18.2%, 29.1% and 7.3% respectively. The charge transport polymer 9 had a multi-branched structure. In the charge transport polymer 9, the number of terminal portions having a crosslinking group represented by formula (1) (the structural unit T1-2 in this case) (the average number per molecule of the polymer) was 74 (calculated from the amounts added of the monomers), which represented 80% of the total of all the structural units T. The structure is shown in the formula below.

[Chemical formula 32]

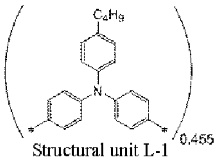

Structural unit L-1

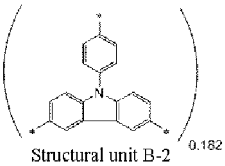

Structural unit B-2

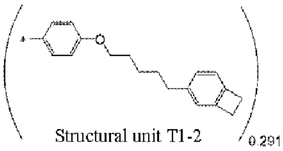

Structural unit T1-2

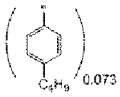

Structural unit T2-3

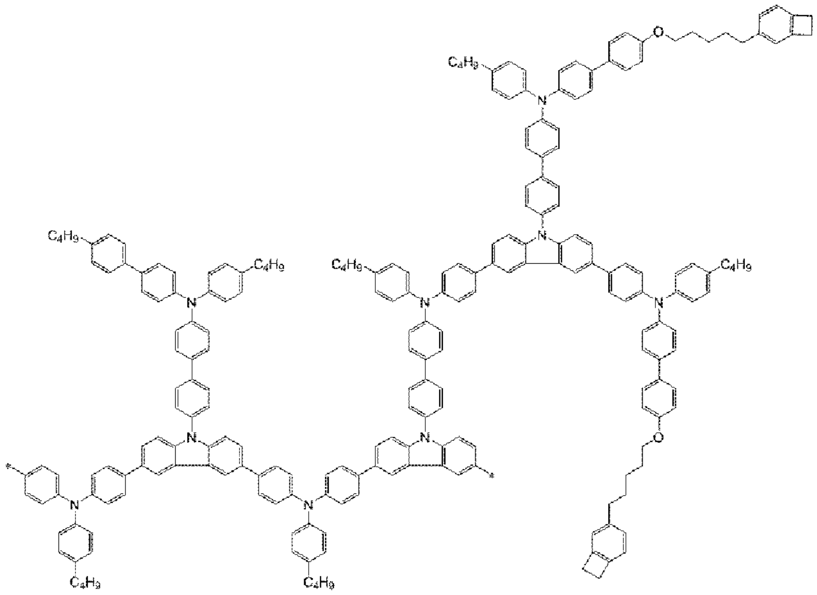

<Synthesis of Charge Transport Polymer 10>

A three-neck round-bottom flask was charged with the monomer L-1 shown above (5.0 mmol), the monomer B-2 shown above (2.0 mmol), the monomer T2-1 shown above (2.0 mmol), the monomer T2-3 shown above (2.0 mmol) and anisole (20 mL), and the prepared Pd catalyst solution (7.5 mL) was then added. Thereafter, a charge transport polymer 10 was synthesized in the same manner as the synthesis of the charge transport polymer 1.

The thus obtained charge transport polymer 10 had a number average molecular weight of 16,300 and a weight average molecular weight of 62,600. The charge transport polymer 10 had a structural unit L-1, a structural unit B-2, a structural unit T2-3, and a structural unit T2-1 having an oxetane group, and the proportions (molar ratios) of those structural units were 45.5%, 18.2%, 18.2% and 18.2% respectively. The charge transport polymer 10 had a multi-branched structure. The charge transport polymer 10 did not have a terminal portion having a crosslinking group represented by formula (1). The structure is shown in the formula below.

[Chemical formula 33]

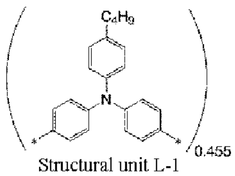

Structural unit L-1

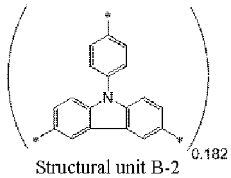

Structural unit B-2

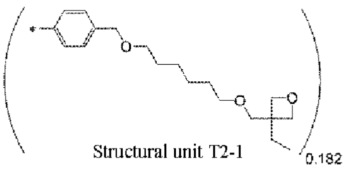

Structural unit T2-1

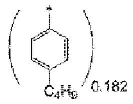

Structural unit T2-3

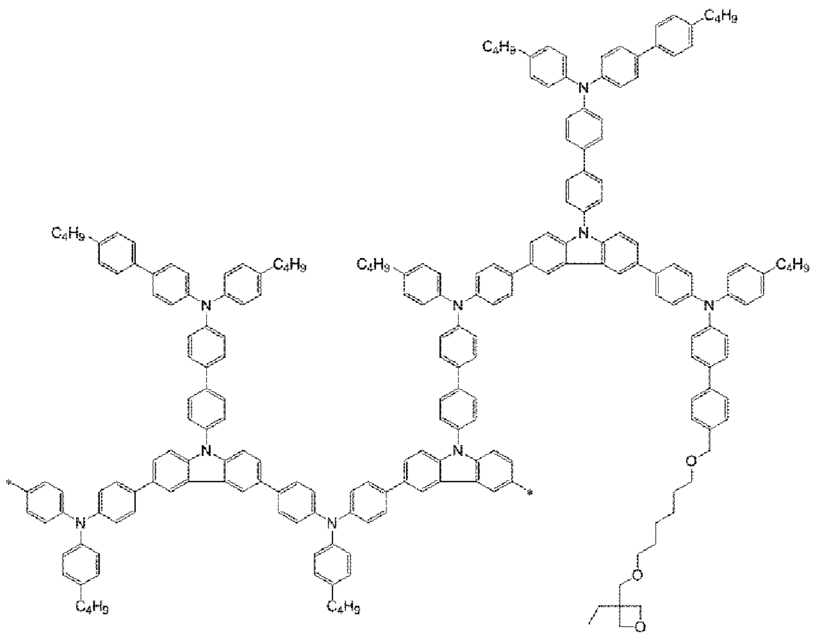

<Synthesis of Charge Transport Polymer 11>

A three-neck round-bottom flask was charged with the monomer L-1 shown above (5.0 mmol), the monomer B-2 shown above (2.0 mmol), a monomer T2-4 shown below (2.0 mmol), the monomer T2-3 shown above (2.0 mmol) and anisole (20 mL), and the prepared Pd catalyst solution (7.5 mL) was then added. Thereafter, a charge transport polymer 11 was synthesized in the same manner as the synthesis of the charge transport polymer 1.

[Chemical formula 34]

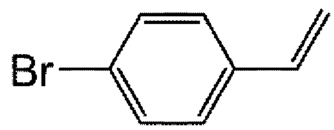

Monomer T2-4

The thus obtained charge transport polymer 11 had a number average molecular weight of 14,500 and a weight average molecular weight of 53,900. The charge transport polymer 11 had a structural unit L-1, a structural unit B-2, a structural unit T2-4 having a vinyl group, and a structural unit T2-3, and the proportions (molar ratios) of those structural units were 45.5%, 18.2%, 18.2% and 18.2% respectively. The charge transport polymer 11 had a multi-branched structure. The charge transport polymer 11 did not have a terminal portion having a crosslinking group represented by formula (1). The structure is shown in the formula below.

[Chemical formula 35]

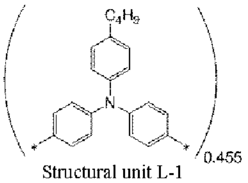

Structural unit L-1

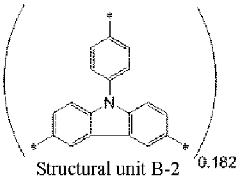

Structural unit B-2

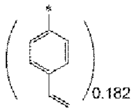

Structural unit T2-4

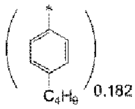

Structural unit T2-3

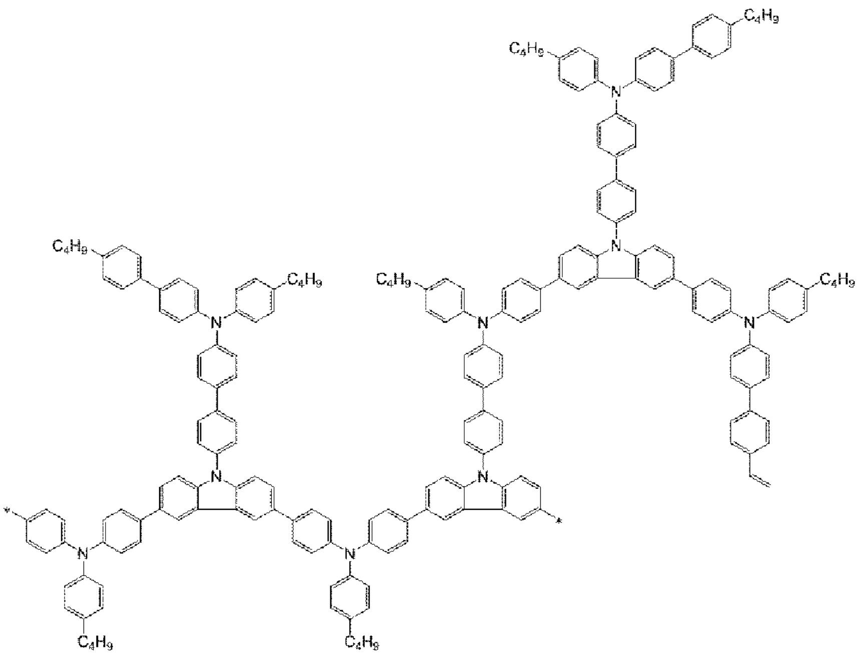

<Synthesis of Charge Transport Polymer 12>

A three-neck round-bottom flask was charged with a monomer L-4 shown below (1.0 mmol), the monomer L-2 shown above (2.0 mmol), the monomer L-3 shown above (2.0 mmol), the monomer B-1 shown above (2.0 mmol), a monomer T2-5 shown below (2.0 mmol), the monomer T2-3 shown above (2.0 mmol) and anisole (20 mL), and the prepared Pd catalyst solution (7.5 mL) was then added. Thereafter, a charge transport polymer 12 was synthesized in the same manner as the synthesis of the charge transport polymer 1.

[Chemical formula 36]

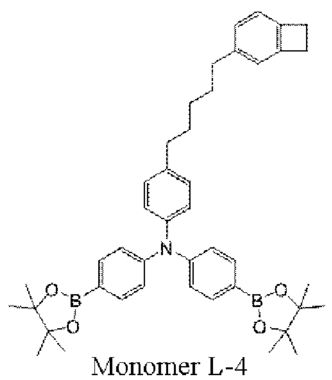

Monomer L-4

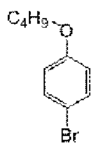

Monomer T2-5

The thus obtained charge transport polymer 12 had a number average molecular weight of 15,000 and a weight average molecular weight of 68,500. The charge transport polymer 12 had a structural unit L-4, a structural unit L-2, a structural unit L-3, a structural unit B-1, a structural unit T2-5, and a structural unit T2-3, and the proportions (molar ratios) of those structural units were 9.1%, 18.2%, 18.2%, 18.2%, 18.2% and 18.2% respectively. The charge transport polymer 12 had a multi-branched structure. In the charge transport polymer 12, the number of the structural units L-4 having a crosslinking group represented by formula (1) (the average number per molecule of the polymer) was 25 (calculated from the amounts added of the monomers). The charge transport polymer 12 did not have the crosslinking groups represented by formula (1) at terminal portions, but rather within the structural unit L. The structure is shown in the formula below.

[Chemical formula 37]

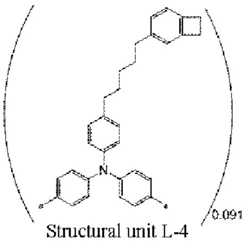

Structural unit L-4

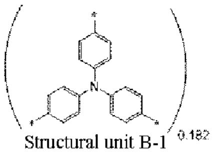

Structural unit B-1

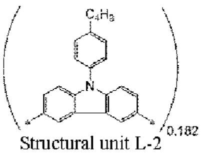

Structural unit L-2

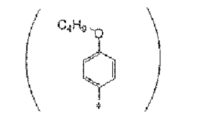

Structural unit T2-5

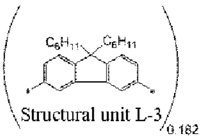

Structural unit L-3

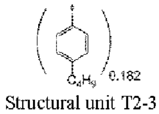

Structural unit T2-3

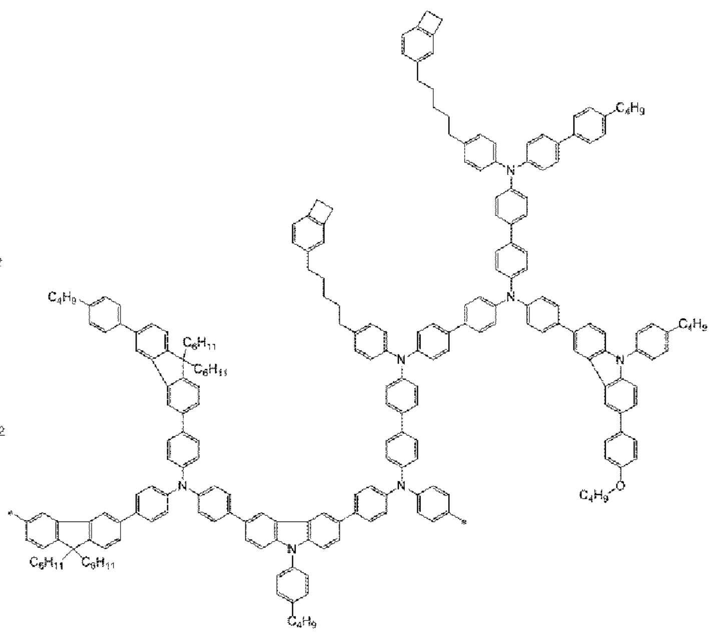

<Synthesis of Charge Transport Polymer 13>

A three-neck round-bottom flask was charged with the monomer L-4 shown above (2.0 mmol), the monomer L-2 shown above (1.5 mmol), the monomer L-3 shown above (1.5 mmol), the monomer B-1 shown above (2.0 mmol), the monomer T2-5 shown above (2.0 mmol), the monomer T2-3 shown above (2.0 mmol) and anisole (20 mL), and the prepared Pd catalyst solution (7.5 mL) was then added. Thereafter, a charge transport polymer 12 was synthesized in the same manner as the synthesis of the charge transport polymer 1.

The thus obtained charge transport polymer 13 had a number average molecular weight of 14,400 and a weight average molecular weight of 66,500. The charge transport polymer 13 had a structural unit L-4, a structural unit L-2, a structural unit L-3, a structural unit B-1, a structural unit T2-5, and a structural unit T2-3, and the proportions (molar ratios) of those structural units were 18.2%, 13.6%, 13.6%, 18.2%, 18.2% and 18.2% respectively. The charge transport polymer 13 had a multi-branched structure. In the charge transport polymer 13, the number of the structural units L-4 having a crosslinking group represented by formula (1) (the average number per molecule of the polymer) was 47 (calculated from the amounts added of the monomers). The charge transport polymer 13 did not have the crosslinking groups represented by formula (1) at terminal portions, but rather within the structural unit L. The structure is shown in the formula below.

[Chemical formula 38]

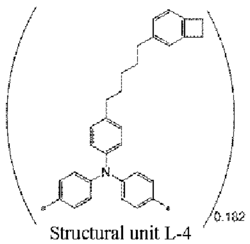

Structural unit L-4

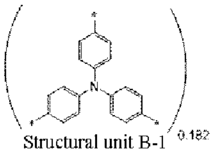

Structural unit B-1

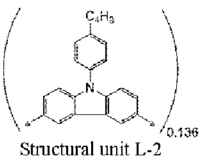

Structural unit L-2

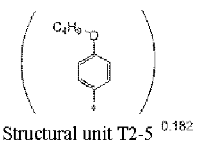

Structural unit T2-5

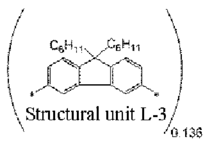

Structural unit L-3

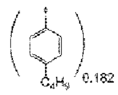

Structural unit T2-3

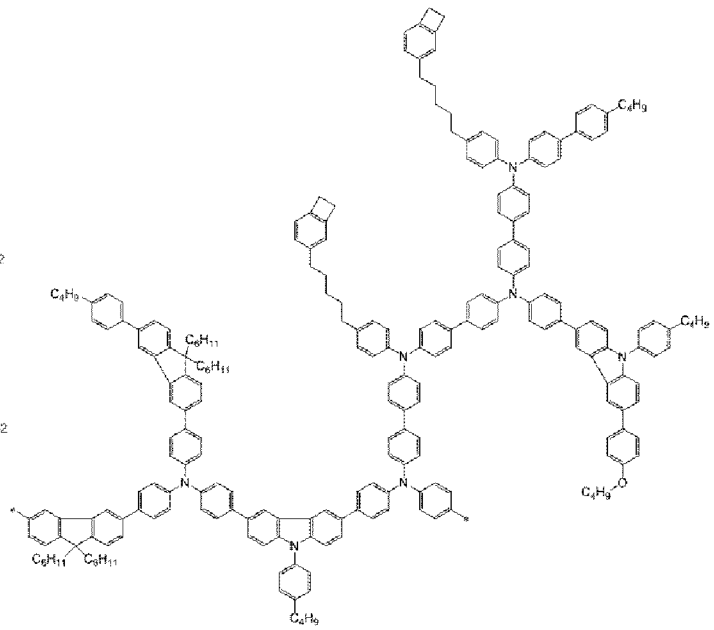

<Measurement and Evaluation of Residual Film Ratio>

[Examples 1 to 8, Comparative Examples 1 to 4]

- Preparation of Liquid Compositions (Ink Compositions)

Each of the charge transport polymers 2 to 9 (Examples 1 to 8) and 10 to 13 (Comparative Examples 1 to 4) was dissolved in toluene, thus preparing a 1% by mass liquid composition (toluene solution) of each of the charge transport polymers.

- Evaluation of Residual Film Ratio on Glass Substrate

Each of these liquid compositions was dripped onto a glass substrate and spin-coated at a rotational rate of 3,000 $min^{-1}$ for 60 seconds using a spin coater (product name: MS-A100, manufactured by Mikasa Co., Ltd.), thus forming a film. Subsequently, using a high-power hot plate (product name: ND-3H, manufactured by AS ONE Corporation) in a glove box under a nitrogen atmosphere, the film on the glass substrate was baked at 230°C for 30 minutes. The absorbance (Abs.1) of the obtained film at the absorption maximum wavelength was measured using a spectrophotometer (product name: U-3310, manufactured by Hitachi High-Technologies Corporation).

Subsequently, the glass substrate was immersed in toluene for 10 seconds, and the toluene was then dried at normal temperature. The absorbance (Abs.2) of the film at the absorption maximum wavelength was then re-measured using the spectrophotometer (product name: U-3310, manufactured by Hitachi High-Technologies Corporation). The value of (Abs.2/Abs.1) × 100 was calculated as the residual film ratio, and was recorded in Table 1.

[Table 1]

| | Charge transport polymer | Residual film ratio (%) |
|---|---|---|
| Example 1 | Charge transport polymer 2 | 97 |
| Example 2 | Charge transport polymer 3 | 99 |
| Example 3 | Charge transport polymer 4 | 100 |
| Example 4 | Charge transport polymer 5 | 100 |
| Example 5 | Charge transport polymer 6 | 100 |

(continued)

| | Charge transport polymer | Residual film ratio (%) |
|---|---|---|
| Example 6 | Charge transport polymer 7 | 100 |
| Example 7 | Charge transport polymer 8 | 100 |
| Example 8 | Charge transport polymer 9 | 100 |
| Comparative Example 1 | Charge transport polymer 10 | 52 |
| Comparative Example 2 | Charge transport polymer 11 | 92 |
| Comparative Example 3 | Charge transport polymer 12 | 80 |
| Comparative Example 4 | Charge transport polymer 13 | 99 |

Examples 1 to 8 which used the charge transport polymers 2 to 9 that had a crosslinking group represented by formula (1) at two or more terminal portions exhibited a higher residual film ratio than the Comparative Examples 1 and 2 which used the charge transport polymers 10 and 11 that did not have a crosslinking group represented by formula (1), confirming superior curability.

Further, in terms of the charge transport polymer 12 used in Comparative Example 3, if the structural unit corresponding with the structural unit L-1 of the charge transport polymer 7 used in Example 6 is replaced with the structural unit L-4, and the structural unit corresponding with the structural unit T1-2 is replaced with the structural unit T2-5, then with the exceptions of the number of crosslinking groups represented by formula (1) (45 in the former and 25 in the latter) and the location of those crosslinking groups (terminal portions in the former and the structural unit L in the latter), the charge transport polymer 7 and the charge transport polymer 12 can be considered to have similar compositions. Compared with Comparative Example 3, Example 6 had more satisfactory curability. It is thought that the residual film ratio decreased because the 25 crosslinking groups in the charge transport polymer 3 used in Comparative Example 3 was less than the 45 crosslinking groups in the charge transport polymer 7 used in Example 6.

Further, although the charge transport polymer 13 used in Comparative Example 4 exhibited superior curability compared with Comparative Examples 1 to 3, it is thought that as described above in the description of the synthesis of each charge transport polymer, this difference in curability is due to the different ratio between the various structural units in the charge transport polymer 7 and the charge transport polymer 12.

As mentioned above, it was confirmed that by introducing the crosslinking groups in a satisfactory amount in order to ensure favorable curability in wet processes, Examples 1 to 8 exhibited improved film formability in wet processes.

<Production of Elements for Evaluating Charge Transportability>

[Examples 9 to 12, Comparative Examples 5 and 6]

An ink composition for forming a hole injection layer was prepared under a nitrogen atmosphere by mixing the charge transport polymer 1 (10.0 mg), an electron-accepting compound 1 shown below (0.5 mg) and toluene (2.3 mL). This ink composition was spin-coated at a rotational rate of 3,000 $min^{-1}$ onto a glass substrate on which ITO had been patterned with a width of 1.6 mm, and the ink composition was then cured by heating at 220°C for 10 minutes on a hot plate, thus forming a hole injection layer (25 nm).

[Chemical formula 39]

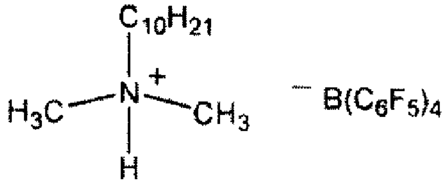

Electron-accepting compound 1

Next, one of the charge transport polymers 2 to 13 shown in Table 2 (10.0 mg) and toluene (1.15 mL) were mixed to prepare an ink composition for forming a hole transport layer. This ink composition was spin-coated at a rotational rate of 3,000 $min^{-1}$ onto the hole injection layer formed above, and was then cured by heating at 230°C for 30 minutes on a hot plate, thus forming a hole transport layer (40 nm). In each example and each comparative example, the hole transport layer was able to be formed without dissolving the hole injection layer.

The substrate obtained on the manner described above was transferred into a vacuum deposition apparatus, Al (100 nm) was deposited onto the hole transport layer, and an encapsulation treatment was performed, thus completing production of an element for evaluating the charge transportability.

A voltage was applied to each of these charge transportability evaluation elements, with the ITO used as the anode and the aluminum used as the cathode. The current-voltage characteristics were measured using a microammeter (4140B manufactured by The Hewlett-Packard Company). The applied voltage when the current density was 50 $mA/cm^2$ is shown in Table 2.

[Table 2]

| | Hole injection layer | Charge transport polymer | Charge transport properties |
|---|---|---|---|
| | | | Applied voltage (V) |
| Example 9 | Charge transport polymer 1 Electron-accepting compound 1 | Charge transport polymer 3 | 3.5 |
| Example 10 | Charge transport polymer 1 Electron-accepting compound 1 | Charge transport polymer 9 | 3.6 |
| Example 11 | Charge transport polymer 1 Electron-accepting compound 1 | Charge transport polymer 7 | 3.6 |
| Example 12 | Charge transport polymer 1 Electron-accepting compound 1 | Charge transport polymer 8 | 3.7 |
| Comparative Example 5 | Charge transport polymer 1 Electron-accepting compound 1 | Charge transport polymer 12 | 3.6 |
| Comparative Example 6 | Charge transport polymer 1 Electron-accepting compound 1 | Charge transport polymer 13 | 2.4 |

As shown in Table 2, if Example 9 and Example 10 are compared, then although the numbers of crosslinking groups in the charge transport polymer 3 and the charge transport polymer 9 are very different at 49 and 74 respectively, the charge transportability value was substantially the same. Further, if Example 11 and Example 12 are compared, then although the numbers of crosslinking groups in the charge transport polymer 7 and the charge transport polymer 8 are very different at 45 and 68 respectively, the charge transportability value was substantially the same.

On the other hand, if Comparative Examples 5 and 6, which used charge transport polymers that had the crosslinking group represented by formula (1) in the structural unit L rather than at the terminal portions, are compared, then the numbers of crosslinking groups in the charge transport polymer 12 and the charge transport polymer 13 were 25 and 47 respectively, and the charge transportability results were very different. It is though that the reason for these observations is that, as described above in the descriptions of the syntheses of the various charge transport polymers, although the charge transport polymer 12 has a similar composition to the charge transport polymer 7, the charge transport polymer 13 required a change in the ratios of the structural units compared with the charge transport polymer 12 in order to achieve satisfactory curability, and it is thought that the change in the amount of crosslinking groups introduced into the polymer caused large changes in the composition of the main chain and/or the side chains, leading to a large change in the ability to transport a charge (hole).

The above results confirmed that by incorporating a charge transport polymer having a crosslinking group represented by formula (1) at two or more terminal portions, even if the number of crosslinking groups introduced into the polymer was changed, the charge transportability remained substantially the same, and changes in the conductivity could be suppressed.

<Production of Organic EL Elements>

[Examples 13 to 20, Comparative Examples 7 to 10]

An ink composition for forming a hole injection layer was prepared under a nitrogen atmosphere by mixing the charge transport polymer 1 (10.0 mg), the electron-accepting compound 1 shown above (0.5 mg) and toluene (2.3 mL). This ink composition was spin-coated at a rotational rate of 3,000 $min^{-1}$ onto a glass substrate on which ITO had been patterned with a width of 1.6 mm, and the ink composition was then cured by heating at 220°C for 10 minutes on a hot plate, thus forming a hole injection layer (thickness: 25 nm).

Next, one of the charge transport polymers 2 to 13 shown in Table 3 (10.0 mg) and toluene (1.15 mL) were mixed to prepare an ink composition for forming a hole transport layer. This ink composition was spin-coated at a rotational rate of 3,000 $min^{-1}$ onto the hole injection layer formed above, and was then cured by heating at 200°C for 10 minutes on a hot plate, thus forming a hole transport layer (thickness: 40 nm). In each example and each comparative example, the hole transport layer was able to be formed without dissolving the hole injection layer.

[Table 3]

| | Hole Injection Layer | Charge transport polymer |
|---|---|---|
| Example 13 | Charge transport polymer 1 Electron-accepting compound 1 | Charge transport polymer 2 |
| Example 14 | Charge transport polymer 1 Electron-accepting compound 1 | Charge transport polymer 3 |
| Example 15 | Charge transport polymer 1 Electron-accepting compound 1 | Charge transport polymer 4 |
| Example 16 | Charge transport polymer 1 Electron-accepting compound 1 | Charge transport polymer 5 |
| Example 17 | Charge transport polymer 1 Electron-accepting compound 1 | Charge transport polymer 6 |
| Example 18 | Charge transport polymer 1 Electron-accepting compound 1 | Charge transport polymer 7 |
| Example 19 | Charge transport polymer 1 Electron-accepting compound 1 | Charge transport polymer 8 |
| Example 20 | Charge transport polymer 1 Electron-accepting compound 1 | Charge transport polymer 9 |
| Comparative Example 7 | Charge transport polymer 1 Electron-accepting compound 1 | Charge transport polymer 10 |
| Comparative Example 8 | Charge transport polymer 1 Electron-accepting compound 1 | Charge transport polymer 11 |
| Comparative Example 9 | Charge transport polymer 1 Electron-accepting compound 1 | Charge transport polymer 12 |
| Comparative Example 10 | Charge transport polymer 1 Electron-accepting compound 1 | Charge transport polymer 13 |

Each of the substrates obtained above was transferred into a vacuum deposition apparatus, layers of CBP:$Ir(ppy)_3$ (94:6, thickness: 30 nm), BAlq (thickness: 10 nm), TPBi (thickness: 30 nm), LiF (thickness: 0.8 nm) and A1 (thickness: 100 nm) were deposited in that order using deposition methods on top of the hole transport layer, and an encapsulation treatment was performed to complete production of an organic EL element. Details of each of the layers are as follows.
CBP:$Ir(ppy)_3$ (94:6, thickness: 30 nm): Light-emitting layer
BAlq (thickness: 10 nm): Hole blocking layer
TPBi (thickness: 30 nm): Electron transport layer
LiF (thickness: 0.8 nm): Electron injection layer

A1 (thickness: 100 nm): Cathode

When a voltage was applied to each of the organic EL elements obtained in Examples 13 to 20 and Comparative Examples 7 to 10, green light emission was confirmed in each case. For each element, the emission lifespan (luminance half-life) when the initial luminance was 5,000 cd/$m^2$ was measured. The measurement results are shown in Table 4.

[Table 4]

| | Hole injection layer | Charge transport polymer | Emission lifespan (h) |
|---|---|---|---|
| Example 13 | Charge transport polymer 1 Electron-accepting compound 1 | Charge transport polymer 2 | 240 |
| Example 14 | Charge transport polymer 1 Electron-accepting compound 1 | Charge transport polymer 3 | 260 |
| Example 15 | Charge transport polymer 1 Electron-accepting compound 1 | Charge transport polymer 4 | 255 |
| Example 16 | Charge transport polymer 1 Electron-accepting compound 1 | Charge transport polymer 5 | 287 |
| Example 17 | Charge transport polymer 1 Electron-accepting compound 1 | Charge transport polymer 6 | 285 |
| Example 18 | Charge transport polymer 1 Electron-accepting compound 1 | Charge transport polymer 7 | 290 |
| Example 19 | Charge transport polymer 1 Electron-accepting compound 1 | Charge transport polymer 8 | 241 |
| Example 20 | Charge transport polymer 1 Electron-accepting compound 1 | Charge transport polymer 9 | 233 |
| Comparative Example 7 | Charge transport polymer 1 Electron-accepting compound 1 | Charge transport polymer 10 | 140 |
| Comparative Example 8 | Charge transport polymer 1 Electron-accepting compound 1 | Charge transport polymer 11 | 160 |
| Comparative Example 9 | Charge transport polymer 1 Electron-accepting compound 1 | Charge transport polymer 12 | 235 |
| Comparative Example 10 | Charge transport polymer 1 Electron-accepting compound 1 | Charge transport polymer 13 | 155 |

As shown in Table 4, comparison of Examples 13 to 20 with Comparative Examples 7 and 8 revealed that by using the organic electronic material according to an embodiment of the present invention in a hole transport layer, an element having a long lifespan could be obtained, confirming an improvement in the lifespan characteristics.

In Examples 13 to 20, the charge transport polymers 2 to 9 were used, but because these polymers do not have crosslinking groups at any positions other than the terminal portions on the main chain (including the side chains), even if the number of introduced crosslinking groups is changed, there is little change in the conductivity. Moreover, because these charge transport polymers have crosslinking groups represented by formula (1) at two or more terminal portions, the polymers exhibit satisfactory curability. Accordingly, even if the crosslinking groups are introduced in a large amount in order to ensure favorable film formability (curability) in wet processes, the charge (hole) transport properties do not change, and it is thought that this is because the light-emitting position (the position of hole and electron recombination) does not differ greatly from the original ideal position (for example, the center of the light-emitting layer).

In contrast, in Comparative Examples 7 and 8, the charge transport polymers 10 and 11 were used, and in a similar manner to Examples 6 to 10, because these polymers do not have crosslinking groups at any positions other than the terminal portions on the main chain (including the side chains), even if the number of introduced crosslinking groups is changed, there is little change in the conductivity. However, because these polymers do not have crosslinking groups represented by formula (1), they lack satisfactory curability. In other words, in Comparative Examples 7 and 8, it is assumed that many crosslinking groups remain in a non-crosslinked state. It is thought that the presence of a large amount of non-crosslinked residual groups accelerates degradation during operation of the organic EL element, causing

the light-emitting position (the position of hole and electron recombination) to deviate from the original ideal position as time elapses, resulting in a shortening of the lifespan.

Further, in Comparative Example 9 which used the charge transport polymer 12, as mentioned above, the lifespan characteristics were similar to those of Example 18, which used the charge transport polymer 7 having a similar composition to the charge transport polymer 12, but the residual film ratio was inferior, meaning that when the light-emitting layer is formed by a coating method, it can be expected that the charge transport polymer 12 will be partially dissolved, resulting in a deterioration in the lifespan characteristics. In Comparative Example 10, which used the charge transport polymer 13 that had the same structural units as the charge transport polymer 12, but in which the ratios of the various structural units were changed to ensure more favorable curability, as mentioned above, although the residual film ratio was able to be maintained, the element lifespan shortened. It is thought that the reason for this lifespan shortening is that, as shown in Table 2, the charge transportability was very different, indicating a large offset in the light-emitting position toward the side of the hole-blocking layer.

Industrial Applicability

The organic electronic material and ink composition containing the charge transport polymer or oligomer of the present invention have superior curability, are suitable for use in wet processes, and are suitable for improving the lifespan characteristics of organic electronic elements. Accordingly, the organic electronic material and ink composition can be applied to organic electronic elements, organic EL elements, display elements, illumination devices, and display devices and the like.

Reference Signs List

1: Light-emitting layer
2: Anode
3: Hole injection layer
4: Cathode
5: Electron injection layer
6: Hole transport layer
7: Electron transport layer
8: Substrate

## Claims

1. An organic electronic material comprising a charge transport polymer or oligomer, wherein
the charge transport polymer or oligomer has a branched structure, and has a crosslinking group represented by formula (1) shown below at two or more terminal portions, and
the branched structure comprises a multi-branched structure having one or more branched portions and three or more chains bonded to one of the one or more branched portions, wherein each of the three or more chains has one or more other branched portions and two or more other chains bonded to one of the one or more other branched portions.

[Chemical formula 1]

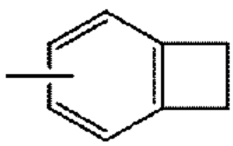

(1)

2. The organic electronic material according to Claim 1, wherein the charge transport polymer or oligomer has three or more terminal portions, and at least two of the three or more terminal portions have a crosslinking group represented by formula (1).

3. The organic electronic material according to Claim 1 or 2, wherein the charge transport polymer or oligomer is a

copolymer of monomers that include at least a monomer containing a structural unit having charge transport properties and a monomer containing a crosslinking group represented by formula (1).

**4.** The organic electronic material according to any one of Claims 1 to 3, wherein the charge transport polymer or oligomer is a copolymer of monomers that include at least a monomer containing a structural unit having hole transport properties and a monomer containing a crosslinking group represented by formula (1).

**5.** The organic electronic material according to any one of Claims 1 to 4, wherein the charge transport polymer or oligomer comprises at least a divalent structural unit L and a monovalent structural unit T1 containing a crosslinking group represented by formula (1), the structural unit L is at least one type of structural unit selected from the group consisting of a structural unit that is a substituted or unsubstituted aromatic amine structure and a structural unit that is a substituted or unsubstituted carbazole structure, the structural unit T1 is a structural unit that is at least one type of structure selected from the group consisting of a structure represented by formula (1), and a substituted or unsubstituted aromatic ring structure to which a crosslinking group represented by formula (1) is bonded via a divalent organic group, and the divalent organic group is a group containing at least one group selected from the group consisting of an aliphatic organic group and a substituted or unsubstituted aromatic organic group.

**6.** The organic electronic material according to Claim 5, wherein the charge transport polymer or oligomer further comprises at least one type of structural unit selected from the group consisting of a trivalent or higher structural unit B and a monovalent structural unit T2 that does not have a crosslinking group represented by formula (1), the structural unit B is a structural unit that is at least one type of structure selected from the group consisting of a substituted or unsubstituted aromatic amine structure, a substituted or unsubstituted carbazole structure and a substituted or unsubstituted condensed polycyclic aromatic hydrocarbon structure, and the structural unit T2 is a structural unit that is a substituted or unsubstituted aromatic ring structure.

**7.** The organic electronic material according to Claim 5 or 6, wherein adjacent structural units are bonded together by a single bond between a carbon atom on an aromatic ring of one structural unit and a carbon atom on an aromatic ring of another structural unit.

**8.** An ink composition comprising the organic electronic material according to any one of Claims 1 to 7, and a solvent.

**9.** An organic layer formed using the organic electronic material according to any one of Claims 1 to 7 or the ink composition according to Claim 8.

**10.** An organic electronic element comprising at least one layer of the organic layer according to Claim 9.

**11.** The organic electronic element according to Claim 10, comprising at least an anode and cathode pair, and the organic layer disposed between the anode and the cathode.

**12.** An organic electroluminescent element comprising at least one layer of the organic layer according to Claim 9.

**13.** An organic electroluminescent element formed by stacking at least a substrate, an anode, a light-emitting layer and a cathode, wherein the light-emitting layer is the organic layer according to Claim 9.

**14.** An organic electroluminescent element formed by stacking at least a substrate, an anode, a hole injection layer, a hole transport layer, a light-emitting layer and a cathode, wherein at least one layer among the hole injection layer, the hole transport layer and the light-emitting layer is the organic layer according to Claim 9.

**15.** The organic electroluminescent element according to Claim 13 or 14, formed by stacking at least a substrate, an anode, a hole injection layer, a hole transport layer, a light-emitting layer, an electron transport layer, an electron injection layer and a cathode.

**16.** The organic electroluminescent element according to any one of Claims 12 to 15, wherein the substrate is a flexible substrate.

**17.** The organic electroluminescent element according to any one of Claims 12 to 16, wherein the substrate is a resin film substrate.

**18.** A display element comprising the organic electroluminescent element according to any one of Claims 12 to 17.

**19.** An illumination device comprising the organic electroluminescent element according to any one of Claims 12 to 17.

**20.** A display device comprising the illumination device according to Claim 19, and a liquid crystal element as a display unit.

FIG. 1

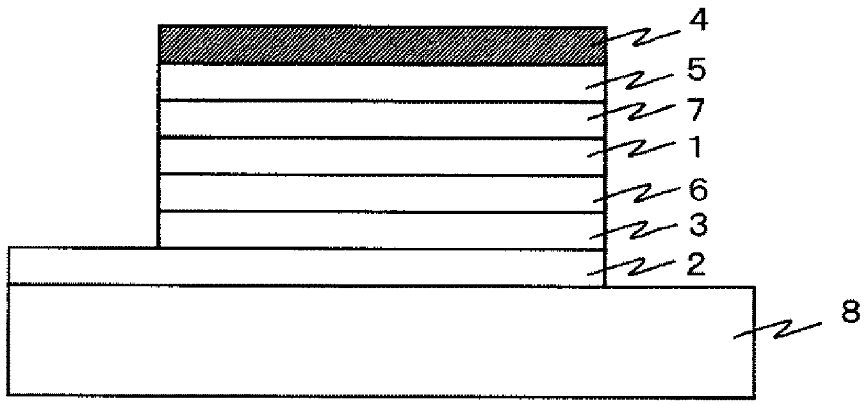

**INTERNATIONAL SEARCH REPORT**

International application No.
PCT/JP2018/002126

A. CLASSIFICATION OF SUBJECT MATTER
Int.Cl. H01L51/50(2006.01)i, C08G61/12(2006.01)i, C08L65/00(2006.01)i, C09D11/00(2014.01)i, F21S2/00(2016.01)i, G02F1/13357(2006.01)i, G09F9/30(2006.01)i, H01L27/32(2006.01)i, F21Y115/15(2016.01)n
According to International Patent Classification (IPC) or to both national classification and IPC

B. FIELDS SEARCHED
Minimum documentation searched (classification system followed by classification symbols)
Int.Cl. H01L51/50, C08G61/12, C08L65/00, C09D11/00, F21S2/00, G02F1/13357, G09F9/30, H01L27/32, F21Y115/15

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | JP 2012-111719 A (IDEMITSU KOSAN CO) 14 June 2012, paragraphs [0047], [0062], [0093] (Family: none) | 1-20 |
| A | JP 2010-155985 A (MITSUBISHI CHEMICAL CORPORATION) 15 July 2010, paragraph [0401] (Family: none) | 1-20 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03.04.2018 | 17.04.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2018/002126

C (Continuation). DOCUMENTS CONSIDERED TO BE RELEVANT

| Category* | Citation of document, with indication, where appropriate, of the relevant passages | Relevant to claim No. |
|---|---|---|
| A | WO 2016/125560 A1 (SUMITOMO CHEMICAL COMPANY, LIMITED) 11 August 2016, paragraph [0426] & EP 3235891 A1, paragraph [0356] & KR 10-2017-0097227 A & CN 107207958 A | 1-20 |
| A | WO 2012/175975 A2 (CAMBRIDGE DISPLAY TECHNOLOGY LIMITED) 27 December 2012, entire text, all drawings & TW 201302812 A | 1-20 |
| A | KR 10-2016-0041124 A (DUK SAN NEOLUX CO., LTD.) 18 April 2016, entire text, all drawings (Family: none) | 1-20 |
| A | ZUNIGA, C. A. et al., Crosslinking using rapid thermal processing for the fabrication of efficient solution-processed phosphorescent organic light-emitting diodes, Adv. Mater., 25 March 2013, vol. 25, pp. 1739-1744 | 1-20 |
| A | MA, B. et al., New thermally cross-linkable polymer and its application as a hole-transporting layer for solution processed multilayer organic light emitting diodes, Chem. Mater., 25 August 2007, vol. 19, pp. 4827-4832 | 1-20 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008106241 A
- JP 2010215886 A
- JP 2017002655 W
- WO 2010140553 A
- JP 2000036390 A
- JP 2005075948 A
- JP 2003213002 A


### Non-patent literature cited in the description


- *Adv. Mater.,* 2009, vol. 21, 4802-4906
- *Appl. Phys. Lett.,* 2011, vol. 98, 083302
- *Chem. Comm.,* 2012, vol. 48, 9580
- *Appl. Phys. Lett.,* 2012, vol. 101, 093306
- *J. Am. Chem. Soc.,* 2012, vol. 134, 14706
- *Chem. Comm.,* 2012, vol. 48, 11392
- *Nature,* 2012, vol. 492, 234
- *Adv. Mater.,* 2013, vol. 25, 3319
- *J. Phys. Chem. A,* 2013, vol. 117, 5607
- *Phys. Chem. Chem. Phys.,* 2013, vol. 15, 15850
- *Chem. Comm.,* 2013, vol. 49, 10385
- *Chem. Lett.,* 2014, vol. 43, 319